# EUROPEAN PATENT APPLICATION

(11) **EP 3 089 367 A1**
(43) Date of publication of application: **02.11.2016**
(21) Application number: 16163877.0
(22) Date of filing: 05.04.2016
(51) Int. Cl.: H03K 17/082, H03K 17/74

(54) **DYNAMIC VOLTAGE-CLAMPING CIRCUIT FOR A SEMICONDUCTOR ELEMENT**

(30) Priority: 27.04.2015 JP 2015090565
(71) Applicant: Renesas Electronics Corporation, Tokyo 135-0061 (JP)
(72) Inventor: NAKAHARA, Akihiro, Koutou-ku, Tokyo 135-0061 (JP); TANAKA, Makoto, Koutou-ku, Tokyo 135-0061 (JP)
(74) Representative: Addiss, John William

(57) **Abstract**

According to one embodiment, a switching control circuit (CTL1) includes a Zener diode (D1) that, when a voltage between a drain (Dr1) and a source (Sr1) of an output transistor (T1) that controls a current flowing through a load (4) exceeds a specified value, allows continuity between the drain (Dr1) and the source (Sr1) of the output transistor (T1), and a current mirror circuit (Tr1, Tr2) that, when a current flows through the Zener diode (D1), allows continuity between the drain (Dr1) and a gate (Gt1) of the output transistor (T1).

## Description

The present invention relates to a semiconductor device, a power controlling semiconductor device, an on-vehicle electronic control unit, and a vehicle including the same and, for example, relates to a semiconductor device, a power controlling semiconductor device, an on-vehicle electronic control unit, and a vehicle including the same that are suitable for accurately driving a load.

An electronic control unit (ECU) that electronically controls an engine and the like is mounted on vehicles such as automobiles and motorcycles. The electronic control unit includes a power controlling semiconductor device (intelligent power device (IPD)) that drives a load such as a solenoid injector placed in an engine. The power controlling semiconductor device is composed of an output transistor that is placed on a current path of a load and a switching control circuit that controls on and off of the output transistor.

In the power controlling semiconductor device, when current supply to an inductive load such as a solenoid or a motor is turned from on to off, electromagnetic energy stored in the load is released and thereby a back electromotive force is generated. In order to prevent the output transistor from breaking down due to the back electromotive force, the power controlling semiconductor device includes a dynamic clamping circuit that clamps the back-electromotive force to a specified clamping voltage. The power controlling semiconductor device that includes the dynamic clamping circuit is disclosed in Japanese Unexamined Patent Publications No. H6-104444, No. H11-261064, No. 2014-165848 and No. 2013-26838, for example.

However, in the power controlling semiconductor device according to related art, because a clamping voltage varies with a change in a load current, an error occurs in a clamping time, which raises a problem that it is not possible to drive the load accurately. The other problems and novel features of the present invention will become apparent from the description of the specification and the accompanying drawings.

According to one embodiment, a semiconductor device includes a voltage limiting circuit that, when a voltage between a first terminal and a second terminal of an output transistor that controls a current flowing through a load exceeds a specified value, allows continuity between the first terminal and the second terminal of the output transistor, and a first current mirror circuit that, when a current flows through the voltage limiting circuit, allows continuity between the first terminal and a control terminal of the output transistor.

According to one embodiment, an on-vehicle electronic control unit includes one or a plurality of power controlling semiconductor devices that control a current flowing through one or a plurality of loads, and a processor that gives an instruction to the one or plurality of power controlling semiconductor devices based on information from a sensor placed externally, wherein each of the one or plurality of power controlling semiconductor devices includes an output transistor that controls a current flowing through the corresponding load, a voltage limiting circuit that, when a voltage between a first terminal and a second terminal of the output transistor exceeds a specified value, allows continuity between the first terminal and the second terminal of the output transistor, and a first current mirror circuit that, when a current flows through the voltage limiting circuit, allows continuity between the first terminal and a control terminal of the output transistor.

According to the above-described embodiment, it is possible to provide a semiconductor device, a power controlling semiconductor device, an on-vehicle electronic control unit, and a vehicle including the same capable of accurately driving a load by accurately controlling a clamping time.

The above and other aspects, advantages and features will be more apparent from the following description of certain embodiments taken in conjunction with the accompanying drawings, in which:
Fig. 1 is an outline view of an automobile equipped with an electronic control system according to a first embodiment.
Fig. 2 is a view showing a specific structure of the electronic control system mounted on the automobile shown in Fig. 1.
Fig. 3 is a view showing another structure example of the electronic control system according to the first embodiment.
Fig. 4 is a view showing a structure example of a power controlling semiconductor device according to the first embodiment.
Fig. 5 is a timing chart showing an operation of the power controlling semiconductor device shown in Fig. 4.
Fig. 6 is a view to describe a difference in effects between the power controlling semiconductor device shown in Fig. 4 and the power controlling semiconductor device shown in Fig. 23.
Fig. 7 is a view showing an example of mounting the power controlling semiconductor device shown in Fig. 4 on a chip.
Fig. 8 is a view showing a first alternative example of the power controlling semiconductor device shown in Fig. 4.
Fig. 9 is a view showing a second alternative example of the power controlling semiconductor device shown in Fig. 4.
Fig. 10 is a view showing a third alternative example of the power controlling semiconductor device shown in Fig. 4.
Fig. 11 is a view showing a fourth alternative example of the power controlling semiconductor device shown in Fig. 4.
Fig. 12 is a view showing a fifth alternative example of the power controlling semiconductor device shown in Fig. 4.
Fig. 13 is a view showing a structure example of a power controlling semiconductor device according to a second embodiment.
Fig. 14 is a view showing a waveform of load dump surge.
Fig. 15 is a view showing an alternative example of the power controlling semiconductor device shown in Fig. 13.
Fig. 16 is a view showing a structure example of a power controlling semiconductor device according to a third embodiment.
Fig. 17 is a timing chart showing an operation of the power controlling semiconductor device shown in Fig. 16.
Fig. 18 is a view showing an example of mounting the power controlling semiconductor device shown in Fig. 16 on a chip.
Fig. 19 is a view showing an alternative example of the power controlling semiconductor device shown in Fig. 16.
Fig. 20 is a view showing a structure example of a power controlling semiconductor device according to a fourth embodiment.
Fig. 21 is a view showing an alternative example of the power controlling semiconductor device shown in Fig. 20.
Fig. 22 is a view to describe the effects of the power controlling semiconductor device shown in Fig. 21 in more detail.
Fig. 23 is a view showing a structure of a power controlling semiconductor device according to an idea before an embodiment has been devised.
Fig. 24 is a timing chart showing an operation of the power controlling semiconductor device shown in Fig. 23.

Embodiments of the present invention are described hereinafter with reference to the drawings. It should be noted that the drawings are given in simplified form by way of illustration only, and thus are not to be considered as limiting the present invention. The same elements are denoted by the same reference symbols, and the redundant explanation is omitted.

In the following embodiments, the description will be divided into a plurality of sections or embodiments when necessary for the sake of convenience. However, unless explicitly specified otherwise, those sections or embodiments are by no means unrelated to each other, but are in such a relation that one represents a modification, a detailed or supplementary description, etc. of part or whole of the other. Further, in the following embodiments, when a reference is made to the number etc, (including the number, numeric value, quantity, range, etc.) of elements, except in such cases where it is explicitly specified otherwise or the number is obviously limited to a specific number in principle, the number is not limited to the specific number but may be greater or less than the specific number.

It is needless to mention that, in the following embodiments, their constituent elements (including operation steps) are not necessarily essential, except in such cases where it is explicitly specified otherwise or they are obviously considered to be essential in principle. Likewise, in the following embodiments, when a reference is made to the shape, relative position, etc. of a constituent element or the like, this includes those shapes etc. substantially resembling or similar to that shape etc., except in such cases where it is explicitly specified otherwise or it is obviously considered otherwise in principle. The same applies to the number etc, (including the number, numeric value, quantity, range, etc.) mentioned above.

### <First Embodiment>

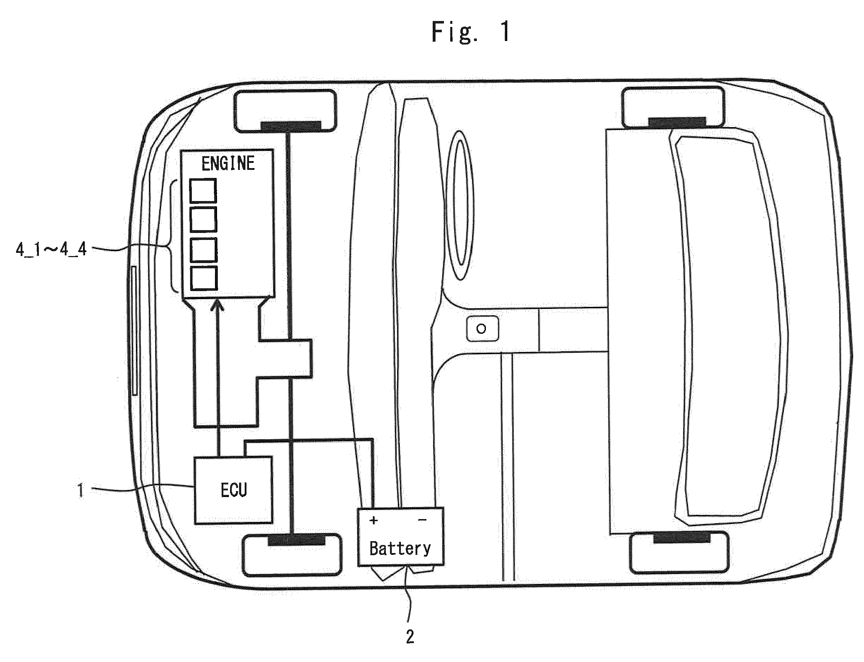

Fig. 1 is an outline view of an automobile equipped with an electronic control system according to a first embodiment. Note that, in Fig. 1, the case where the electronic control system is a system that controls fuel injection of a four-cylinder engine of an automobile is described as an example.

As shown in Fig. 1, an electronic control system SYS1 that is mounted on an automobile includes an electronic control unit (on-vehicle electronic control unit) 1 placed in the interior or engine room of the automobile, for example, a battery power supply 2 that supplies a power supply voltage to the electronic control unit 1, and solenoid injectors 4_1 to 4_4, which are load to be driven by the electronic control unit 1.

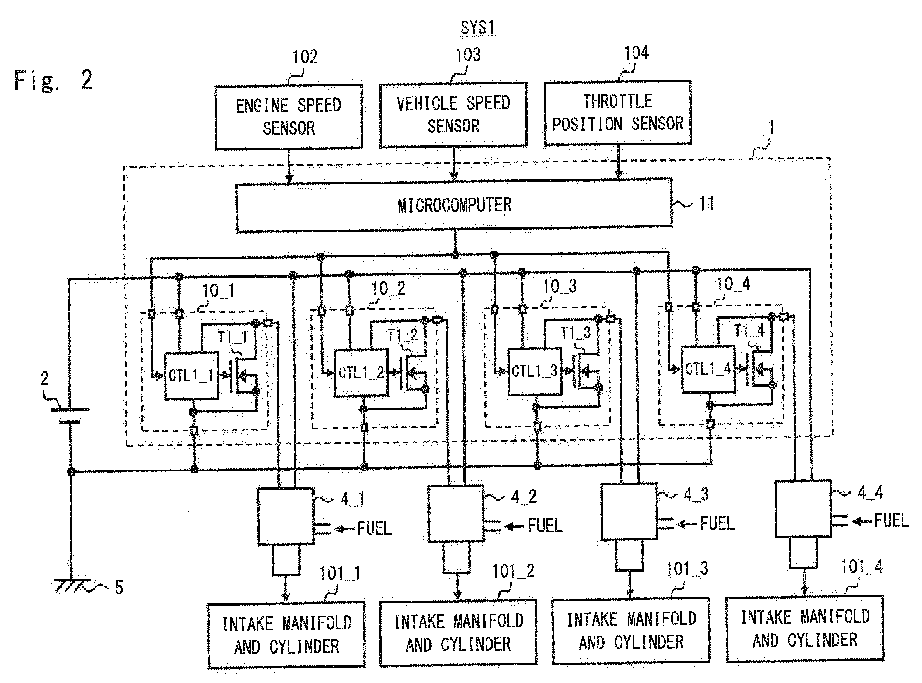

Fig. 2 is a view showing a specific structure of the electronic control system SYS1 mounted on the automobile shown in Fig. 1. As shown in Fig. 2, the electronic control system SYS1 includes the electronic control unit 1, the battery power supply 2, the solenoid injectors 4_1 to 4_4 serving as loads, intake manifold and cylinders 101_1 and 101_4, an engine speed sensor 102, a vehicle speed sensor 103, and a throttle position sensor 104.

The electronic control unit 1 includes a microcomputer (processor) 11 and power controlling semiconductor devices 10_1 to 10_4 that control the current flowing to the solenoid injectors 4_1 to 4_4, respectively.

The power controlling semiconductor device 10_1 includes an output transistor T1_1 placed between the battery power supply 2 and the solenoid injector 4_1, and a switching control circuit CTL1_1 that controls on and off of the output transistor T1_1. The power controlling semiconductor device 10_2 includes an output transistor T1_2 placed between the battery power supply 2 and the solenoid injector 4_2, and a switching control circuit CTL1_2 that controls on and off of the output transistor T1_2. The power controlling semiconductor device 10_3 includes an output transistor T1_3 placed between the battery power supply 2 and the solenoid injector 4_3, and a switching control circuit CTL1_3 that controls on and off of the output transistor T1_3. The power controlling semiconductor device 10_4 includes an output transistor T1_4 placed between the battery power supply 2 and the solenoid injector 4_4, and a switching control circuit CTL1_4 that controls on and off of the output transistor T1_4.

Specifically, in the example of Fig. 2, each of the output transistors T1_1 to T1_4 is used as a low-side switch. Further, each of the switching control circuits CTL1_1 to CTL1_4 includes an active clamping circuit that clamps a back-electromotive force that is generated by an inductive load when the output transistors T1_1 to T1_4 turn from on to off to a clamping voltage. The details of the active clamping circuit are described later.

A stabilized power supply voltage, which is not shown, is supplied to the microcomputer 11. The microcomputer 11 gives instructions to the power controlling semiconductor devices 10_1 to 10_4 based on sensing results of the engine speed sensor 102, the vehicle speed sensor 103, the throttle position sensor 104 and the like. The switching control circuits CTL1_1 to CTL1_4 control on and off of the output transistors T1_1 to T1_4, respectively, based on instructions (external input signals) from the microcomputer 11. The current flowing to the solenoid injectors 4_1 to 4_4 is thereby controlled. The solenoid injectors 4_1 to 4_4 inject fuel during a period when the current is supplied. The injected fuel is supplied to the intake manifold and cylinders 101_1 and 101_4, respectively.

Note that, although the fuel injection time is basically determined by the time when the output transistors T1_1 to T1_4 turn on in response to instructions from the microcomputer 11, in the case where the active clamping circuit operates due to the generation of a back-electromotive force, the fuel injection time is also affected by the time when the output transistors T1_1 to T1_4 turn on at that time (clamping time). Because the clamping time is a wasteful time during which the solenoid injectors cannot be driven, it is demanded to reduce that time as much as possible. By reducing the clamping time, it is possible to improve the engine combustion efficiency.

### (Other Structure Example of Electronic Control System SYS1)

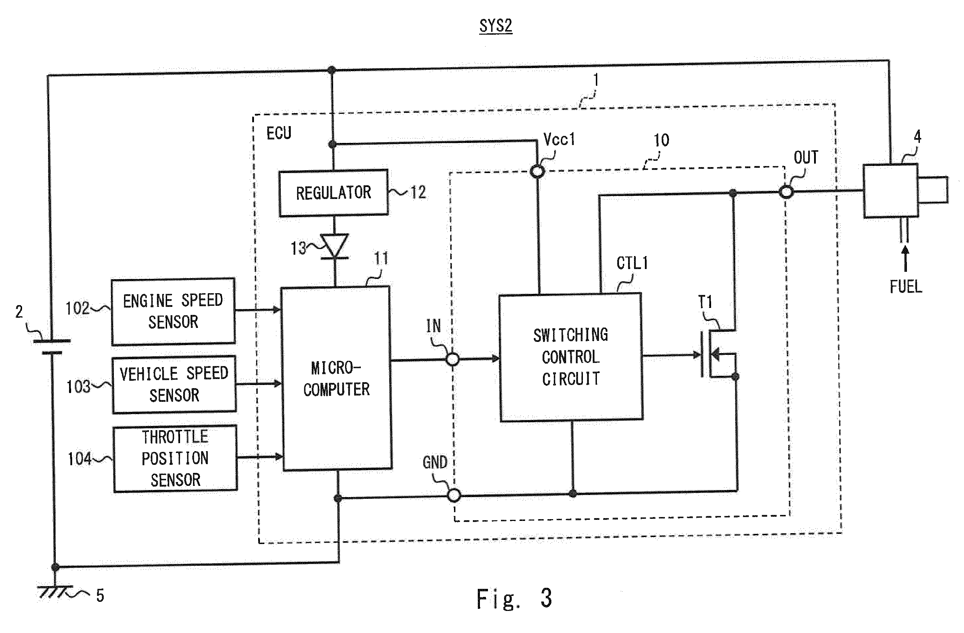

Fig. 3 shows another structure example of the electronic control system SYS1 as an electronic control system SYS2. In Fig. 3, the case where the electronic control system SYS2 is mounted on a motorcycle is described as an example.

As shown in Fig. 3, the electronic control system SYS2 that is mounted on a motorcycle includes an electronic control unit 1, a battery power supply 2 that supplies a power supply voltage to the electronic control unit, a solenoid injector 4 which is a load to be driven by the electronic control unit 1, an engine speed sensor 102, a vehicle speed sensor 103, and a throttle position sensor 104.

The electronic control unit 1 includes a microcomputer 11, a power controlling semiconductor device 10 that controls the current flowing to the solenoid injector 4, a regulator 12, and a diode 13.

The power controlling semiconductor device 10 includes an output transistor T1 placed between the battery power supply 2 and the solenoid injector 4, and a switching control circuit CTL1 that controls on and off of the output transistor T1. Thus, in the example of Fig. 3, the output transistor T1 is used as a low-side switch. Further, the switching control circuit CTL1 includes an active clamping circuit that clamps a back-electromotive force that is generated by an inductive load when the output transistor T1 turns from on to off to a clamping voltage. The details of the active clamping circuit are described later.

A power supply voltage of the battery power supply 2 is converted into an optimum voltage by the regulator 12 and then supplied to the microcomputer 11. Further, in order to prevent the breakdown of the microcomputer 11 when the battery power supply 2 is incorrectly connected in a reversed position, the diode 13 for backflow prevention is placed between the microcomputer 11 and the regulator 12.

The microcomputer 11 gives an instruction to the power controlling semiconductor device 10 based on sensing results of the engine speed sensor 102, the vehicle speed sensor 103, the throttle position sensor 104 and the like. The switching control circuit CTL1 controls on and off of the output transistor T1 based on an instruction (external input signal) from the microcomputer 11. The current flowing to the solenoid injector 4 is thereby controlled. The solenoid injector 4 injects fuel during a period when the current is supplied. The injected fuel is supplied to an intake manifold and cylinder (not shown).

Note that, although the fuel injection time is basically determined by the time when the output transistor T1 turns on in response to an instruction from the microcomputer 11, in the case where the active clamping circuit operates due to the generation of a back-electromotive force, the fuel injection time is also affected by the time when the output transistor T turns on at that time (clamping time). Because the clamping time is wasteful time during which the solenoid injector cannot be driven, it is demanded to reduce that time as much as possible. By reducing the clamping time, it is possible to improve the engine combustion efficiency.

### (Previous Studies by the Inventors)

Before describing the details of the power controlling semiconductor device 10 placed in the electronic control system of an automobile, a motorcycle and the like described above, a power controlling semiconductor device 50 that has been previously studied by the present inventors is described hereinbelow.

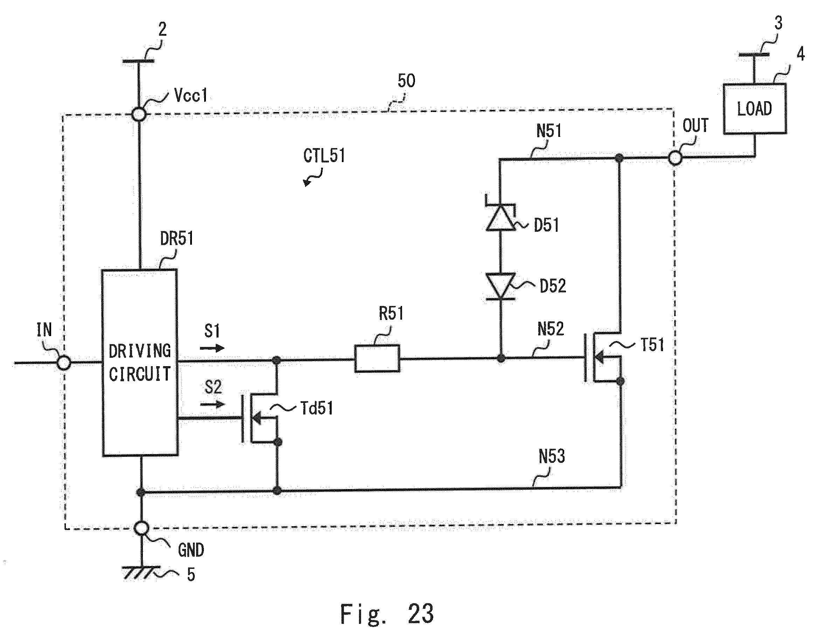

Fig. 23 is a block diagram showing a structure of the power controlling semiconductor device 50 according to the idea before the embodiment has been devised.

As shown in Fig. 23, the power controlling semiconductor device 50 includes an output transistor T51, a driving circuit DR51, a discharge transistor Td51, a Zener diode D51, a diode D52, and a resistor element R51. Note that the driving circuit DR51, the discharge transistor Td51, the Zener diode D51, the diode D52 and the resistor element R51 constitute a switching control circuit (semiconductor device) CTL51. Hereinafter, the case where both of the output transistor T51 and the discharge transistor Td51 are N-channel MOS transistors is described as an example.

A power supply voltage (which is also referred to hereinafter as a power supply voltage Vcc1) from a battery power supply 2 is supplied to a power supply voltage terminal Vcc1, and a ground voltage (which is also referred to hereinafter as a ground voltage GND) from a ground power supply 5 is supplied to a ground voltage terminal GND. Further, an external input signal is supplied from an external device such as a microcomputer to an input terminal IN. An inductive load 4 such as a solenoid injector placed in an engine is connected to an output terminal OUT. Note that, although a power supply voltage from a battery power supply 3 is supplied to the load 4, a power supply voltage from the battery power supply 2 may be supplied to the load 4.

The drain and the source of the output transistor T51 are connected to the output terminal OUT and the ground voltage terminal GND, respectively. Then, a control signal S1 from the driving circuit DR51 is supplied to the gate of the output transistor T51 through the resistor element R51. Thus, the output transistor T51 is used as a low-side switch that controls the current flowing to the load 4.

The drain of the discharge transistor Td51 is electrically connected to the gate of the output transistor T51 through the resistor element R51, and the source of the discharge transistor Td51 is connected to the source of the output transistor T51. Then, a control signal S2 from the driving circuit DR51 is supplied to the gate of the discharge transistor Td51.

The driving circuit DR51 is driven by the power supply voltage Vcc1 and the ground voltage GND, and the driving circuit DR51 outputs the control signals S1 and S2 in accordance with an external input signal that is supplied from the outside to the input terminal IN.

For example, in the case where the external input signal at H level is supplied in order to drive the load 4, the driving circuit DR51 outputs the control signal S1 at H level and the control signal S2 at L level. As a result, the control signal S1 at H level is supplied to the gate of the output transistor T51, and the discharge transistor Td51 turns off by the control signal S2 at L level, and thereby the output transistor T51 turns on.

On the other hand, in the case where the external input signal at L level is supplied in order to stop driving the load 4, the driving circuit DR51 outputs the control signal S1 at L level and the control signal S2 at H level. As a result, the control signal S1 at L level is supplied to the gate of the output transistor T51. Further, because the discharge transistor Td51 turns on by the control signal S2 at H level, the gate charge of the output transistor T51 is discharged to the ground voltage terminal GND through the resistor element R51 and the discharge transistor Td51. The output transistor T51 thereby turns off.

The Zener diode D51 and the diode D52 form a dynamic clamping circuit that protects the output transistor T51 from overvoltage. Generally, when current supply to the inductive load 4 is switched from on to off, electromagnetic energy stored in the load 4 is released and thereby a back-electromotive force is generated. The dynamic clamping circuit clamps the voltage of the output terminal OUT to a specified clamping voltage in order to prevent the breakdown of the output transistor T51 due to the back-electromotive force.

To be specific, the cathode of the Zener diode D51 is connected to the output terminal OUT, and the anode of the Zener diode D51 is connected to the anode of the diode D52. The cathode of the diode D52 is connected to the gate of the output transistor T51.

Then, when the voltage of the output terminal OUT (to be more specific, a differential voltage between the output terminal OUT and the ground voltage terminal GND) exceeds a clamping voltage which is the sum of a breakdown voltage of the Zener diode D51, a forward voltage of the diode D52 and a threshold voltage of the output transistor T51, the voltage of the output terminal OUT is clamped to the clamping voltage.

### (Operation of Power Controlling Semiconductor Device 50)

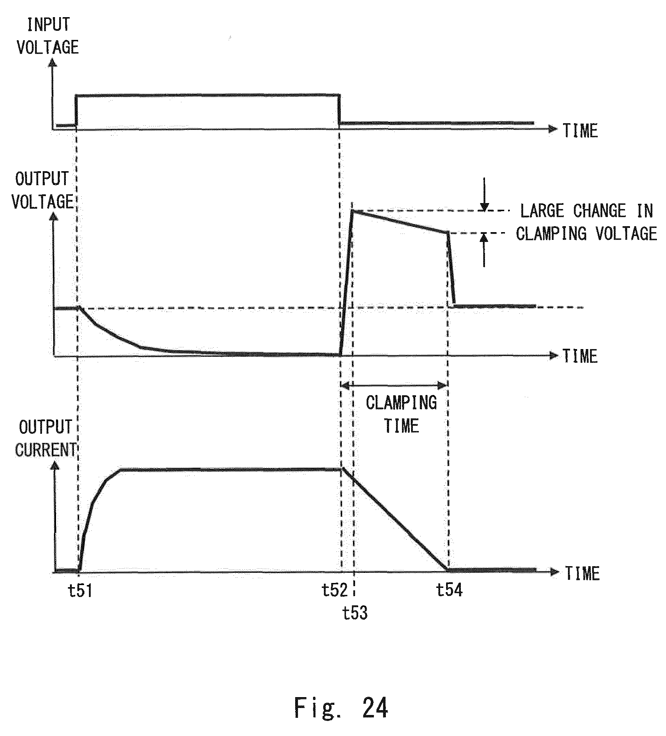

The operation of the power controlling semiconductor device 50 is described hereinafter with reference to Fig. 24.

Fig. 24 is a timing chart showing the operation of the power controlling semiconductor device 50. The case where the output transistor T51 turns on when the external input signal is H level and the output transistor T51 turns off when the external input signal is L level is described as an example.

First, when the external input signal changes from L level to H level (time t51), the driving circuit DR51 outputs the control signal S1 at H level and the control signal S2 at L level. As a result, the control signal S1 at H level is supplied to the gate of the output transistor T51, and the discharge transistor Td51 turns off by the control signal S2 at L level, and thereby the output transistor T51 turns on. Consequently, the current flows from the battery power supply 3 to the load 4. Note that, although the gate voltage of the output transistor T51 becomes higher than the drain voltage at this time, the backflow of the current from the gate to the drain of the output transistor T51 is prevented by the diode D52.

After that, when the external input signal changes from H level to L level (time t52), the driving circuit DR51 outputs the control signal S1 at L level and the control signal S2 at H level. As a result, the control signal S1 at L level is supplied to the gate of the output transistor T51. Further, because the discharge transistor Td51 turns on by the control signal S2 at H level, the gate charge of the output transistor T51 is discharged to the ground voltage terminal GND through the resistor element R51 and the discharge transistor Td51. The output transistor T51 thereby turns off. Consequently, the current flowing from the battery power supply 3 to the load 4 is cut off (time t54).

When the output transistor T51 is on, electromagnetic energy is stored in the inductive load 4. Thus, when the output transistor T51 is switched from on to off, the electromagnetic energy stored in the load 4 is released, and a back-electromotive force is generated in the forward direction in the output terminal OUT. Consequently, a higher voltage than the battery power supply 3 is induced in the output terminal OUT (time t53).

When the voltage of the output terminal OUT becomes higher than the clamping voltage by the back-electromotive force, the current flows from the output terminal OUT to the ground voltage terminal GND through the Zener diode D51, the diode D52, the resistor element R51 and the discharge transistor Td51. The output transistor T51 thereby turns on because its gate voltage increases. The current thereby flows from the output terminal OUT to the ground voltage terminal GND through the output transistor T51, and the voltage of the output terminal OUT is clamped to the clamping voltage (time t53 to time t54).

Note that the clamping voltage is set to such a value that clamping is performed before the drain-source voltage of the output transistor T51 exceeds the breakdown voltage. It is thereby possible to prevent the characteristics degradation and breakdown of the output transistor T51.

However, in the structure of the power controlling semiconductor device 50, the clamping voltage varies with a change in a load current (current flowing through the output terminal OUT), and it is thus not possible to control the clamping time accurately. Thus, the power controlling semiconductor device 50 has a problem that it cannot drive the load 4 accurately. This is specifically described hereinbelow.

In the structure of the power controlling semiconductor device 50, the clamping voltage is the sum of the breakdown voltage of the Zener diode D51, the forward voltage of the diode D52 and the threshold voltage of the output transistor T51 as described above. Because the threshold voltage of the output transistor T51 becomes lower as the current flowing through the output terminal OUT is lower, the clamping voltage becomes lower accordingly. In the actual clamping operation, while the value of the current flowing through the output terminal OUT is large and the clamping voltage is high at the start of clamping, the value of the current flowing through the output terminal OUT becomes smaller and the clamping voltage becomes lower with the lapse of time. Consequently, the clamping time becomes longer than intended despite that it is a wasteful time during which the inductive load cannot be driven. Further, the clamping time changes also when the type of the load changes because the load current varies.

Particularly, in a fuel injection system such as an automobile or a motorcycle that controls fuel injection using a solenoid injector, the amount of fuel injection is controlled by a fuel injection time. The fuel injection time is the sum of a time to intentionally turn on the output transistor T51 and a time when the output transistor turns on when the active clamping circuit operates (clamping time). While the time to intentionally turn on the output transistor T51 is accurately controlled by the microcomputer or the like, the clamping time becomes longer than intended as described above, and therefore an error in the fuel injection time that occurs by an increase in the clamping time affects fuel consumption or the like. Thus, it is significantly important to reduce the clamping time as much as possible, which is, to control the clamping time accurately.

In view of the above, a power controlling semiconductor device 10 according to this embodiment has been invented in order to accurately
control the clamping time and accurately drive the load.

### (Structure of Power Controlling Semiconductor Device 10)

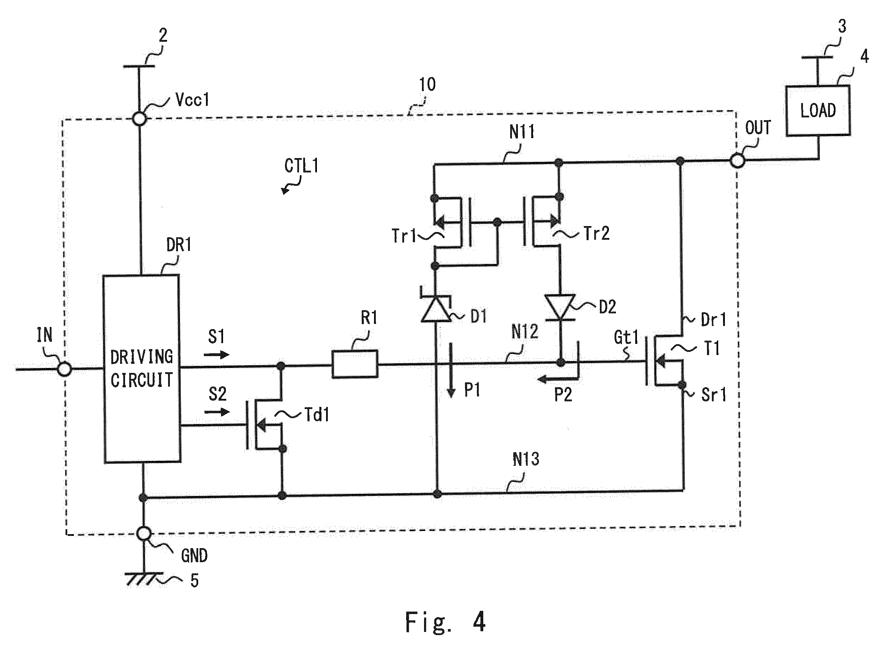

Fig. 4 is a view showing a structure example of the power controlling semiconductor device 10.

As shown in Fig. 4, the power controlling semiconductor device 10 includes an output transistor T1, a driving circuit DR1, a discharge transistor Td1, a Zener diode (voltage limiting circuit) D1, a diode D2, a resistor element R1, a transistor Tr1, and a transistor Tr2. Note that the driving circuit DR1, the discharge transistor Td1, the Zener diode D1, the diode D2, the resistor element R1 and the transistors Tr1 and Tr2 form a switching control circuit (semiconductor device) CTL1.

Hereinafter, the case where both of the output transistor T1 and the discharge transistor Td1 are N-channel power MOS transistors, and both of the transistors Tr1 and Tr2 are P-channel MOS transistors is described as an example. Note that, however, both of the output transistor T1 and the discharge transistor Td1 may be NPN bipolar transistors, and both of the transistors Tr1 and Tr2 may be PMP bipolar transistors.

A power supply voltage (which is also referred to hereinafter as a power supply voltage Vcc1) from a battery power supply 2 is supplied to a power supply voltage terminal Vcc1, and a ground voltage (which is also referred to hereinafter as a ground voltage GND) from a ground power supply 5 is supplied to a ground voltage terminal GND. Further, an external input signal is supplied from an external device such as a microcomputer to an input terminal IN.

An inductive load 4 such as a solenoid injector placed in an engine is connected between an output terminal OUT and a battery power supply 3. Note that the battery power supply 3 and the battery power supply 2 may be in common.

The drain (terminal) Dr1 of the output transistor T1 is connected to the output terminal OUT through a node N11, and the source (terminal) Sr1 of the output transistor T1 is connected to the ground voltage terminal GND through a node N13. Then, a control signal S1 from the driving circuit DR1 is supplied to the gate (control terminal) Gt1 of the output transistor T1 through the resistor element R1 and a node N12. Thus, the output transistor T1 is used as a low-side switch that controls the current flowing to the load 4.

The drain of the discharge transistor Td1 is electrically connected to the gate Gt1 of the output transistor T1 through the resistor element R1, and the source of the discharge transistor Td1 is connected to the source Sr1 of the output transistor T1. Then, a control signal S2 from the driving circuit DR1 is supplied to the gate of the discharge transistor Td1.

The driving circuit DR1 is driven by the power supply voltage Vcc1 and the ground voltage GND, and the driving circuit DR1 outputs the control signals S1 and S2 in accordance with an external input signal that is supplied from the outside to the input terminal IN.

For example, in the case where the external input signal at H level is supplied in order to drive the load 4, the driving circuit DR1 outputs the control signal S1 at H level and the control signal S2 at L level. As a result, the control signal S1 at H level is supplied to the gate Gt1 of the output transistor T1, and the discharge transistor Td1 turns off by the control signal S2 at L level, and thereby the output transistor T1 turns on.

On the other hand, in the case where the external input signal at L level is supplied in order to stop driving the load 4, the driving circuit DR1 outputs the control signal S1 at L level and the control signal S2 at H level. As a result, the control signal S1 at L level is supplied to the gate Gt1 of the output transistor T1. Further, because the discharge transistor Td1 turns on by the control signal S2 at H level, the charge at the gate Gt1 of the output transistor T1 is discharged to the ground voltage terminal GND through the resistor element R1 and the discharge transistor Td1. The output transistor T1 thereby turns off.

The Zener diode D1, the diode D2 and the transistors Tr1 and Tr2 form a dynamic clamping circuit that protects the output transistor T1 from overvoltage. Generally, when current supply to the inductive load 4 is switched from on to off, electromagnetic energy stored in the load 4 is released and thereby a back-electromotive force is generated. The dynamic clamping circuit clamps the voltage of the output terminal OUT to a clamping voltage in order to prevent the breakdown of the output transistor T1 due to the back-electromotive force.

To be specific, in the transistor Tr1, the source is connected to the output terminal OUT (in other words, the drain Dr1 of the output transistor T1), and the drain and the gate are connected to the gate of the transistor Tr2 and the cathode of the Zener diode D1. The anode of the Zener diode D1 is connected to the source Sr1 of the output transistor T1. In the transistor Tr2, the source is connected to the output terminal OUT, and the drain is connected to the anode of the diode D2. The cathode of the diode D2 is connected to the gate Gt1 of the output transistor T1. The transistors Tr1 and Tr2 form a current mirror circuit.

Then, when the voltage of the output terminal OUT (to be more specific, a differential voltage between the output terminal OUT and the ground voltage terminal GND) exceeds a clamping voltage which is the sum of a breakdown voltage of the Zener diode D1 and a threshold voltage of the transistor Tr1, the voltage of the output terminal OUT is clamped to the clamping voltage.

### (Operation of Power Controlling Semiconductor Device 10)

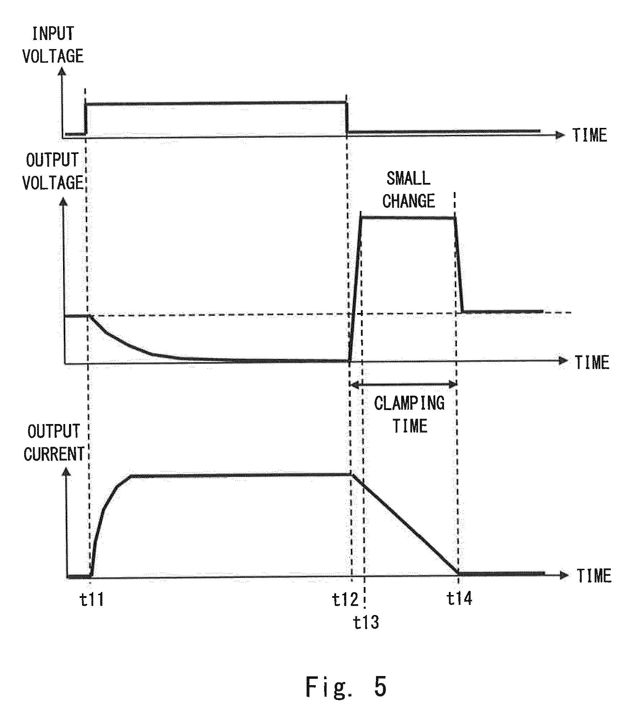

The operation of the power controlling semiconductor device 10 is described hereinafter with reference to Fig. 5.

Fig. 5 is a timing chart showing the operation of the power controlling semiconductor device 10. The case where the output transistor T1 turns on when the external input signal is H level and the output transistor T1 turns off when the external input signal is L level is described as an example.

First, when the external input signal turns from L level to H level (time t11), the driving circuit DR1 outputs the control signal S1 at H level and the control signal S2 at L level. As a result, the control signal S1 at H level is supplied to the gate Gt1 of the output transistor T1, and the discharge transistor Td1 turns off by the control signal S2 at L level, and thereby the output transistor T1 turns on. Consequently, the current flows from the battery power supply 3 to the load 4. Note that, although the gate voltage of the output transistor T1 becomes higher than the drain voltage at this time, the backflow of the current from the gate Gt1 of the output transistor T1 to the drain Dr1 of the output transistor T1 through the transistor Tr2 is prevented by the diode D2.

After that, when the external input signal changes from H level to L level (time t12), the driving circuit DR1 outputs the control signal S1 at L level and the control signal S2 at H level. As a result, the control signal S1 at L level is supplied to the gate Gt1 of the output transistor T1. Further, because the discharge transistor Td1 turns on by the control signal S2 at H level, the charge at the gate Gt1 of the output transistor T1 is discharged to the ground voltage terminal GND through the resistor element R1 and the discharge transistor Td1. The output transistor T1 thereby turns off. Consequently, the current flowing from the battery power supply 3 to the load 4 is cut off (time t14).

When the output transistor T1 is on, electromagnetic energy is stored in the inductive load 4. Thus, when the output transistor T1 is switched from on to off, the electromagnetic energy stored in the load 4 is released, and a back-electromotive force is generated in the forward direction in the output terminal OUT. Consequently, a higher voltage than the battery power supply 3 is induced in the output terminal OUT (time t13).

When the voltage of the output terminal OUT becomes higher than the clamping voltage (= the breakdown voltage of the Zener diode D1 + the threshold voltage of the transistor Tr1) by the back-electromotive force, the current starts flowing from the output terminal OUT to the ground voltage terminal GND through the transistor Tr1 and the Zener diode D1 (which is also referred to hereinafter as a current path P1). The current that is proportional to the current flowing through the transistor Tr1 thereby flows through the transistor Tr2. In other words, the current flows from the output terminal OUT to the ground voltage terminal GND through the transistor Tr2, the diode D2, the resistor element R1 and the discharge transistor Td1 (which is also referred to hereinafter as a current path P2). The output transistor T1 thereby turns on because its gate voltage increases. The current thereby flows from the output terminal OUT to the ground voltage terminal GND through the output transistor T1, and the voltage of the output terminal OUT is clamped to the clamping voltage (time t13 to time t14). At this time, the current flowing through the output terminal OUT (the current flowing through the load 4) continuously decreases exponentially by the release of electromagnetic energy.

Note that the clamping voltage is set to such a value that clamping is performed before the voltage between the drain Dr1 and the source Sr1 of the output transistor T1 exceeds the breakdown voltage. It is thereby possible to prevent the characteristics degradation and breakdown of the output transistor T1.

As described above, the clamping voltage is the sum of the breakdown voltage of the Zener diode D1 and the threshold voltage of the transistor Tr1. Thus, the clamping voltage does not change with a change in the current of the output terminal OUT. The clamping time is thereby controlled accurately. Further, the clamping voltage during the clamping operation is maintained at a high value. Accordingly, the clamping time is reduced. Consequently, the power controlling semiconductor device 10 can accurately drive the load 4.

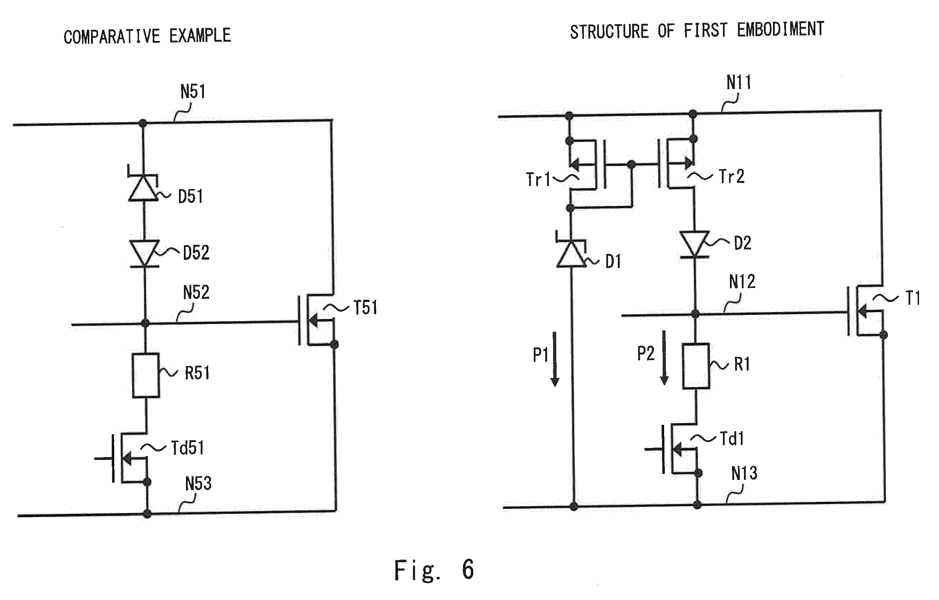

Fig. 6 is a view to describe a difference in effects between the power controlling semiconductor device 10 and the power controlling semiconductor device 50. It becomes evident from the following description
that the clamping voltage of the power controlling semiconductor device 10 does not depend on the load current.

As shown in Fig. 6, the clamping voltage of the power controlling semiconductor device 50 according to a comparative example is the sum of the breakdown voltage of the Zener diode D51, the forward voltage of the diode D52 and the threshold voltage of the output transistor T51. The breakdown voltage of the Zener diode D51 and the forward voltage of the diode D52 are constant values without depending on the load current. On the other hand, the threshold voltage of the output transistor T51 varies with a change in the load current. Therefore, while the load current is high and the clamping voltage is high at the start of clamping, the load current becomes lower and the clamping voltage becomes lower with the lapse of a clamping time. Thus, the clamping voltage has a large dependence on the load current. As a result, the clamping time becomes longer than intended.

On the other hand, the clamping voltage of the power controlling semiconductor device 10 according to this embodiment is the sum of the breakdown voltage of the Zener diode D1 and the threshold voltage of the transistor Tr1. Because the current path that determines the clamping voltage is formed between the drain Dr1 and the source Sr1 of the output transistor T1, the breakdown voltage of the Zener diode D1 and the threshold voltage of the transistor Tr1 are constant values without depending on the load current. Therefore, the clamping voltage during the clamping operation is a constant high value. Thus, the clamping voltage does not substantially have a dependence on the load current. As a result, the clamping time is reduced as intended.

As described above, in the structure of the power controlling semiconductor device 10, the clamping voltage does not change with a change in the current flowing through the output terminal OUT, and therefore the clamping time is controlled accurately. To be specific, the clamping time is reduced. Consequently, the power controlling semiconductor device 10 can accurately drive the load 4. For example, when the power controlling semiconductor device 10 is mounted on the electronic control system of an automobile, a motorcycle or the like, it is possible to minimize the fuel injected during the clamping time. Further, because it is possible to correctly predict the clamping time, it is possible to accurately estimate the amount of fuel injection in consideration of the clamping time. As a result, it is possible to improve the engine fuel efficiency.

Note that, in the case of the structure where the supply source of a gate voltage for forcibly turning on the output transistor T1 at the time of clamping and the supply source of a power supply voltage to be supplied to the load 4 are different, if the supply source of the gate voltage is not connected, it is unable to forcibly turn on the output transistor T1 even when the voltage of the output terminal OUT increases due to the back-electromotive force. Further, in the case where a bipolar transistor is placed for controlling the gate voltage of the output transistor T1, it is necessary to limit a voltage to be applied to the bipolar transistor by limiting the load current, and therefore the reduction of the load current during clamping becomes slower. As a result, the clamping time becomes longer.

On the other hand, in the structure of the power controlling semiconductor device 10, the supply source of a gate voltage for forcibly turning on the output transistor T1 at the time of clamping and the supply source of a power supply voltage to be supplied to the load 4 are the same. Therefore, the power controlling semiconductor device 10 can reliably turn on the output transistor T1 when the voltage of the output terminal OUT increases by the back-electromotive force.

Although the case where the output transistor T1 is used as a low side switch is described as an example in this embodiment, it is not limited thereto, and the output transistor T1 may be used as a high side switch.

### (Chip Mounting Example)

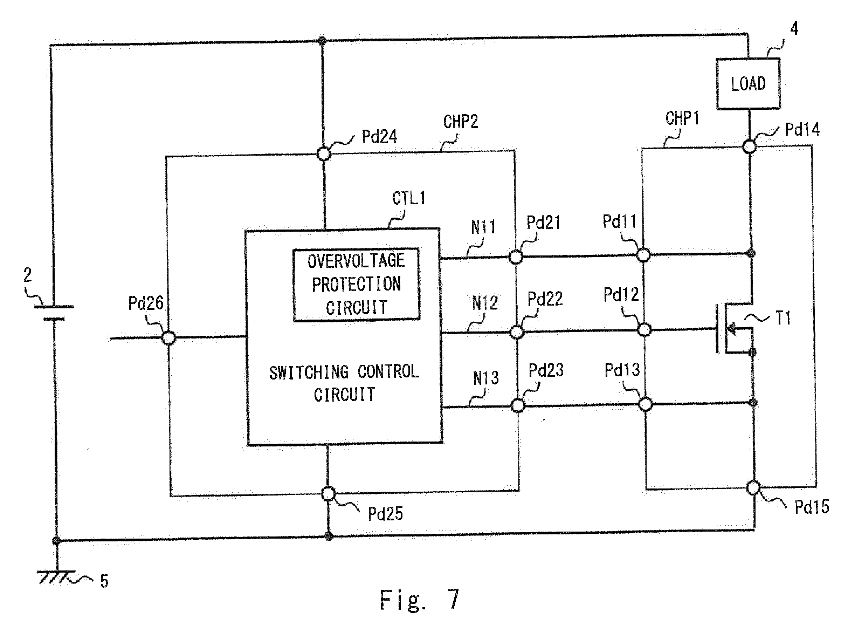

Fig. 7 is a view showing an example of mounting the power controlling semiconductor device 10 on a chip.

In the example of Fig. 7, the output transistor T1 and the switching control circuit CTL1 that constitute the power controlling semiconductor device 10 are placed on a chip CHP1 and a chip CHP2, respectively. Note that, however, the output transistor T1 and the switching control circuit CTL1 that constitute the power controlling semiconductor device 10 may be formed in monolithic.

The switching control circuit CTL1 that is placed on the chip CHP2 is supplied with an input signal for controlling on and off of the output transistor T1 from the outside through a pad Pd26, supplied with a power supply voltage from the battery power supply 2 through a pad Pd24, and supplied with a ground voltage from the ground power supply 5 through a pad Pd25. Then, nodes N11 to N13 of the switching control circuit CTL1 are connected with the drain Dr1, the gate Gt1 and the source Sr1 of the output transistor T1 placed on the chip CHP1 through pads Pd21 to Pd23 on the chip CHP2 and pads Pd11 to Pd13 on the chip CHP1. Note that the chips CHP1 and CHP2 are connected by a bonding wire.

Note that, in addition to an overvoltage protection circuit, another protection circuit may be placed in the switching control circuit CTL1. For example, an overcurrent protection circuit (not shown) that protects the output transistor T1 from overcurrent, an over temperature protection circuit (not shown) that protects the output transistor T1 from over temperature and the like may be placed in the switching control circuit CTL1. Further, terminals and pads for outputting output results of those protection circuits to the outside may be further placed. The state of the power controlling semiconductor device 10 is recognizable by observing the output results of those protection circuits, and it is thereby possible to enhance the safety of the function.

### (First Alternative Example of Power Controlling Semiconductor Device 10)

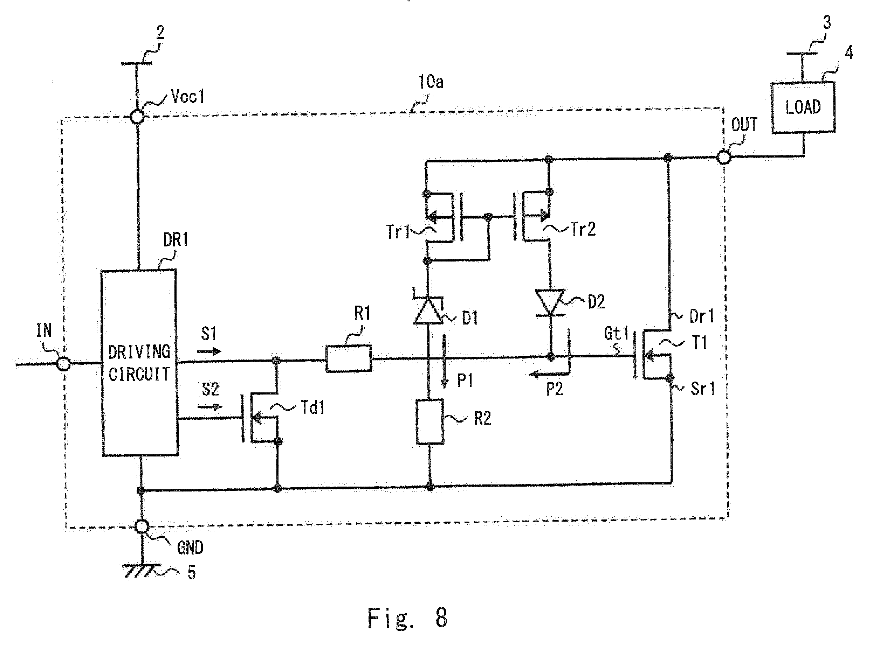

Fig. 8 is a view showing a first alternative example of the power controlling semiconductor device 10 as a power controlling semiconductor device 10a.

As shown in Fig. 8, the power controlling semiconductor device 10a is different from the power controlling semiconductor device 10 in that it further includes a resistor element R2 that is connected in series to the transistor Tr1 and the Zener diode D1. The other structure of the power controlling semiconductor device 10a is the same as that of the power controlling semiconductor device 10 and thus not redundantly described.

The resistor element R2 serves as a current limiting element that limits the current flowing through the Zener diode D1 when the current path P1 is continuous. By limiting the current flowing through the Zener diode D1, it is possible to stabilize the breakdown voltage of the Zener diode D1.

Note that, in place of the resistor element R2, an element that can limit the current flowing through the Zener diode D1, such as an N-channel MOS transistor with shortcircuited gate and drain or a depletion N-channel MOS transistor, may be placed.

### (Second Alternative Example of Power Controlling Semiconductor Device 10)

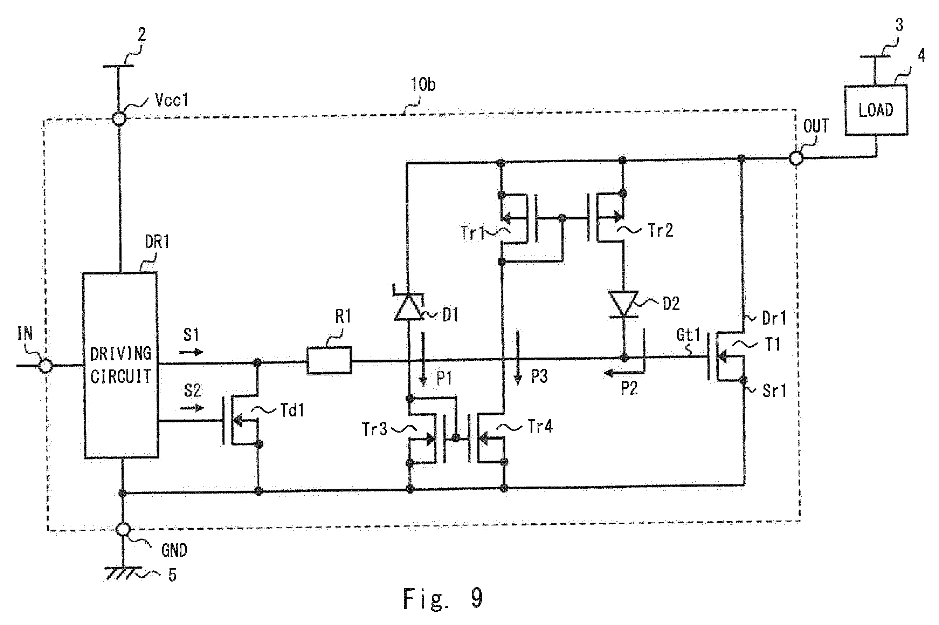

Fig. 9 is a view showing a second alternative example of the power controlling semiconductor device 10 as a power controlling semiconductor device 10b.

As shown in Fig. 9, the power controlling semiconductor device 10b is different from the power controlling semiconductor device 10 in that it further includes a transistor Tr3 and a transistor Tr4. Hereinafter, the case where the transistors Tr3 and Tr4 are N-channel MOS transistors is described as an example.

In the structure of the power controlling semiconductor device 10b, the Zener diode D1 and the transistor Tr3 are placed on the current path P1, and the transistor Tr1 and the transistor Tr4 are placed on a current path (current path P3), which is different from the current path P1.

To be specific, the cathode of the Zener diode D1 is connected to the output terminal OUT. In the transistor Tr3, the drain and the gate are connected to the anode of the Zener diode D1 and the gate of the transistor Tr4, and the source is connected to the source Sr1 of the output transistor T1. In the transistor Tr1, the source is connected to the output terminal OUT, and the drain and the gate are connected to the gate of the transistor Tr2 and the drain of the transistor Tr4. The source of the transistor Tr4 is connected to the source Sr1 of the output transistor T1.

Note that the transistors Tr3 and Tr4 form a current mirror circuit. Further, the transistor Tr3 serves as a current limiting element that limits the current flowing through the Zener diode D1 when the current path P1 is continuous. By limiting the current flowing through the Zener diode D1, it is possible to stabilize the breakdown voltage of the Zener diode D1.

When the voltage of the output terminal OUT becomes higher than the clamping voltage, which is the sum of the breakdown voltage of the Zener diode D1 and the threshold voltage of the transistor Tr3, due to the back-electromotive force or the like, a current starts flowing from the output terminal OUT to the ground voltage terminal GND through the Zener diode D1 and the transistor Tr3 (which is a current path P1). The current that is proportional to the current flowing through the transistor Tr3 thereby flows through the transistor Tr4. In other words, the current flows from the output terminal OUT to the ground voltage terminal GND through the transistors Tr1 and Tr4 (which is a current path P3). The current that is proportional to the current flowing through the transistor Tr1 thereby flows through the transistor Tr2. In other words, the current flows from the output terminal OUT to the ground voltage terminal GND through the transistor Tr2, the diode D2, the resistor element R1 and the discharge transistor Td1 (which is a current path P2). The output transistor T1 thereby turns on because its gate voltage increases. The current thereby flows from the output terminal OUT to the ground voltage terminal GND through the output transistor T1, and the voltage of the output terminal OUT is clamped to the clamping voltage.

In the power controlling semiconductor device 10b, just like the case of the power controlling semiconductor device 10, the clamping voltage does not change with a change in the current flowing through the output terminal OUT, and therefore the clamping voltage during the clamping operation is maintained at a high value. The power controlling semiconductor device 10b can thereby accurately control the clamping time and accurately drive the load 4.

### (Third Alternative Example of Power Controlling Semiconductor Device 10)

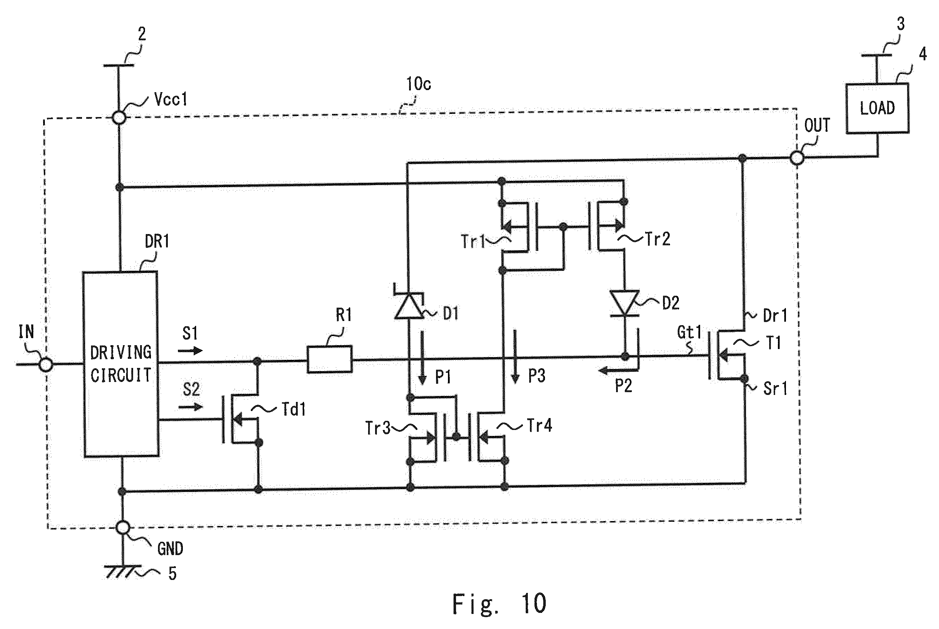

Fig. 10 is a view showing a third alternative example of the power controlling semiconductor device 10 as a power controlling semiconductor device 10c.

As shown in Fig. 10, the power controlling semiconductor device 10c is different from the power controlling semiconductor device 10b in the place to which the higher voltage sides of the current paths P2 and P3 are connected. To be specific, the sources of the transistors Tr1 and Tr2 are connected to the power supply voltage terminal Vcc1, instead of the output terminal OUT. The other structure of the power controlling semiconductor device 10c is the same as that of the power controlling semiconductor device 10b and thus not redundantly described.

The power controlling semiconductor device 10c has substantially the same effects as the power controlling semiconductor device 10 even when the current supply source is different between the current path P1 and the current paths P2 and P3.

### (Fourth Alternative Example of Power Controlling Semiconductor Device 10)

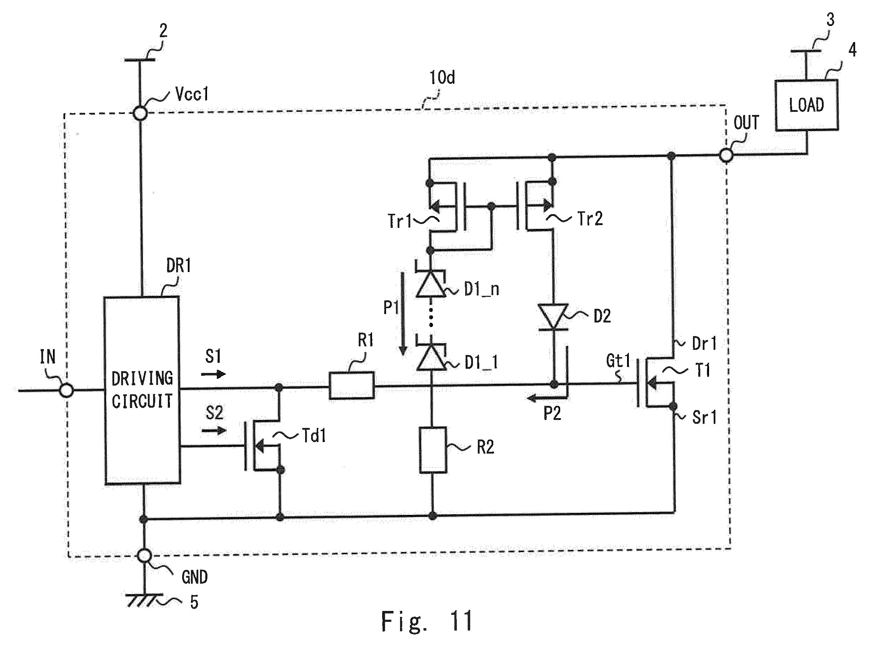

Fig. 11 is a view showing a fourth alternative example of the power controlling semiconductor device 10 as a power controlling semiconductor device 10d.

As shown in Fig. 11, the power controlling semiconductor device 10d is different from the power controlling semiconductor device 10a in that it includes a plurality of Zener diodes D1_1 to D1_n (n is an integer of 2 or above) that are connected in series, instead of the single Zener diode D1. For each of the Zener diodes D1_1 to D1_n, a Zener diode with a breakdown voltage of about 6V and with a low temperature dependence is used. The other structure of the power controlling semiconductor device 10d is the same as that of the power controlling semiconductor device 10a and thus not redundantly described.

Each of the Zener diodes D1_1 to D1_n is formed by joining a P-type semiconductor and an N-type semiconductor, and their breakdown voltage and temperature characteristics of a breakdown voltage are determined by the concentration of the P-type semiconductor and the N-type semiconductor. Further, in general, the breakdown of a diode occurs by the Zener breakdown phenomenon in a region with a low breakdown voltage, and it occurs by the avalanche breakdown phenomenon in a region with a high breakdown voltage. Thus, a negative temperature dependence is observed in a region with a low breakdown voltage, and a positive temperature dependence is observed in a region with a high breakdown voltage.

A breakdown voltage of about 6V is on the border between breakdown occurring by the Zener breakdown phenomenon and breakdown occurring by the avalanche breakdown phenomenon. Thus, the temperature dependence of the Zener diode with a breakdown voltage of about 6V is significantly low. Further, because the Zener diode with a breakdown voltage of about 6V is formed by high-concentration P-type semiconductor and N-type semiconductor, the concentration does not vary widely, and therefore the breakdown voltage does not vary widely. Thus, by using the plurality of Zener diodes D1_1 to D1_n with a breakdown voltage of about 6V, it is possible to achieve a dynamic clamping circuit with less manufacturing variation and less temperature variation. It is thus possible to achieve a dynamic clamping circuit with less variation in a clamping time.

### (Fifth Alternative Example of Power Controlling Semiconductor Device 10)

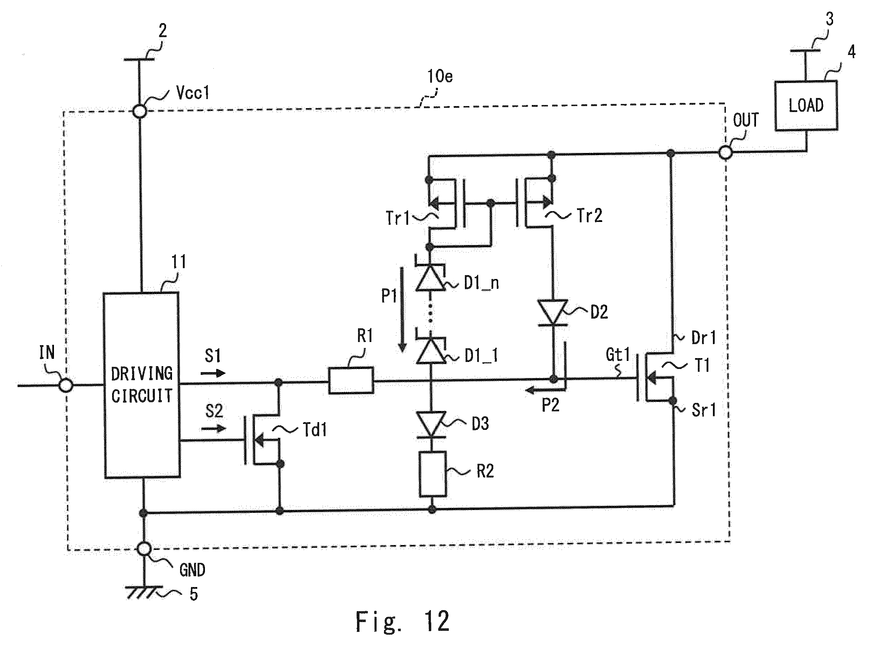

Fig. 12 is a view showing a fifth alternative example of the power controlling semiconductor device 10 as a power controlling semiconductor device 10e.

As shown in Fig. 12, the power controlling semiconductor device 10e is different from the power controlling semiconductor device 10d in that it further includes a diode D3 that is connected in series and reversed to the plurality of Zener diodes D1_1 to D1_n. To be specific, the anode of the diode D3 is connected to the anode of the Zener diode D1_1, and the cathode of the diode D3 is connected to one end of the resistor element R2.

The diode D3 is used together with the plurality of Zener diodes D1_1 to D1_n for further reduction of the temperature dependence of the current path P1. To be specific, when the plurality of Zener diodes D1_1 to D1_n show a positive temperature dependence, by placing the diode D3 having a negative temperature dependence, it is possible to further reduce the temperature dependence of the current path P1.

Note that, in place of the single diode D3, a plurality of diodes D3_1 to D3_m (m is an integer of 2 or above) connected in series may be placed. The number of Zener diodes D1 and the diodes D3 may be set arbitrarily.

### <Second Embodiment>

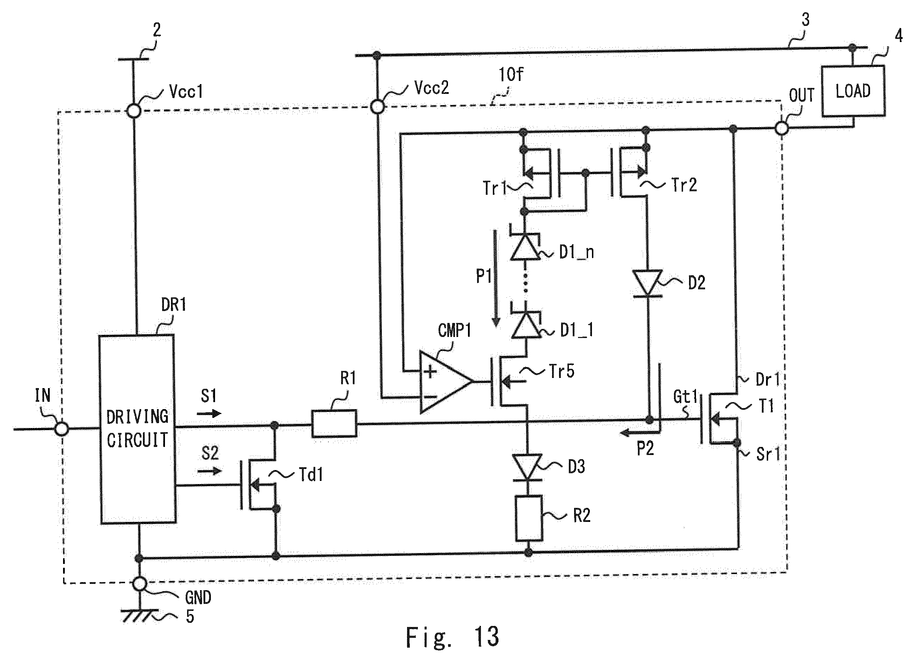

Fig. 13 is a view showing a structure example of a power controlling semiconductor device 10f according to a second embodiment.

The power controlling semiconductor device 10f has a function of inactivating the overvoltage protection function of an output transistor T1 when a surge voltage is generated due to load dump or the like in order to prevent the surge voltage from being applied to an electronic control system. This is specifically described hereinbelow.

In vehicles such as automobiles and motorcycles, for example, when a battery power supply is disconnected from an alternator (generator) due to breaking of a power supply line or the like, which is, when load dump occurs, the load of the alternator changes and a surge voltage is induced at a power supply voltage terminal (Vcc2).

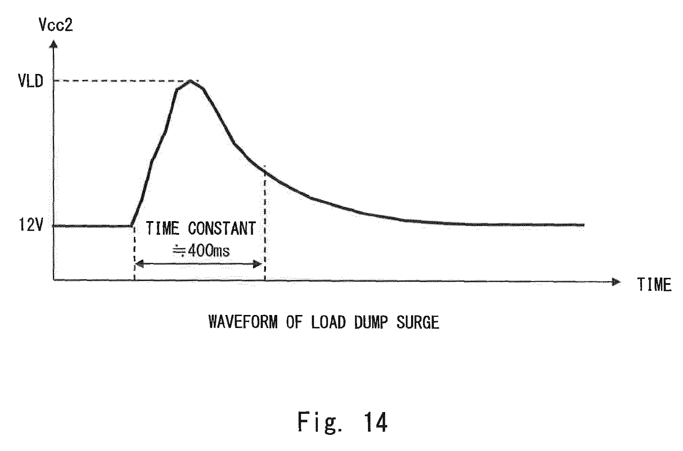

Fig. 14 is a view showing a waveform of load dump surge.

Referring to Fig. 14, the load dump surge has a time constant of about 400ms, and it appears as a positive voltage of the power supply voltage terminal (Vcc2). Generally, when a battery power supply of 12V is used, a surge voltage by load dump is clamped to 40V on the electronic control system.

Because the load dump surge has much greater energy than electromagnetic energy of an inductive load, when the active clamping circuit operates when the load dump surge is generated, there is a possibility that the output transistor T1 undergoes a thermal failure. Therefore, it is common to design the device to satisfy the relationship of the breakdown voltage of the output transistor T1 > the clamping voltage > the surge voltage by load dump so that the active clamping circuit does not operate even when the load dump surge is generated.

However, the breakdown voltage and the on-resistance per unit area of the output transistor T1 are in the relationship of trade-off, and if the output transistor T1 has the same on-resistance, the chip area is larger and the cost is higher as the breakdown voltage is higher. Therefore, it is desirable that the breakdown voltage of the output transistor T1 is as low as possible. To be specific, when the surge voltage due to load dump is 40V at the highest, it is desirable that the breakdown voltage of the output transistor T1 is designed to be 40V at the lowest.

In view of the above, the power controlling semiconductor device 10f includes a dynamic clamping circuit that becomes active at the occurrence of the back-electromotive force and becomes inactive at the occurrence of the load dump surge, thereby making it possible to reduce the breakdown voltage of the output transistor T1 down to approximately the surge voltage.

### (Structure of Power Controlling Semiconductor Device 10f)

As shown in Fig. 13, the power controlling semiconductor device 10f is different from the power controlling semiconductor device 10e in that it further includes a transistor Tr5 and a comparator CMP1. Further, the power controlling semiconductor device 10f further includes a power supply voltage terminal Vcc2 to which a power supply voltage (which is also referred to hereinafter as a power supply voltage Vcc2) from the battery power supply 3 is supplied.

Hereinafter, the case where the transistor Tr5 is an N-channel MOS transistor is described as an example. Note that, however, the transistor Tr5 may be an NPN bipolar transistor.

The comparator CMP1 compares a voltage of the power supply voltage terminal Vcc2 (which is a power supply voltage of the battery power supply 3) with a voltage of the output terminal OUT and outputs a result of the comparison. To be specific, in the comparator CMP1, the non-inverting input terminal is connected to the output terminal OUT, the inverting input terminal is connected to the power supply voltage terminal Vcc2, and the output terminal is connected to the gate of the transistor Tr5.

The transistor Tr5 is placed on the current path P1 and switches on and off based on the comparison result of the comparator CMP1, thereby controlling the continuity of the current path P1. To be specific, in the transistor Tr5, the source is connected to the anode of the diode D3, the drain is connected to the anode of the Zener diode D1_1, and the comparison result of the comparator CMP1 is supplied to the gate.

The back-electromotive force that is induced at the output terminal OUT by the inductive load 4 and the surge voltage that is induced at the power supply voltage terminal Vcc2 by load dump are both positive voltages. Thus, which of the back-electromotive force and the load dump surge is generated is determined by comparing the voltage of the output terminal OUT and the voltage of the power supply voltage terminal Vcc2 with use of the comparator CMP1.

For example, when the voltage of the output terminal OUT increases by the back-electromotive force, the voltage of the output terminal OUT becomes higher than the voltage of the power supply voltage terminal Vcc2, and thereby the comparator CMP1 outputs a comparison result at H level. The transistor Tr5 thereby turns on, and the current path P1 that passes through the Zener diodes D1_1 to D1_n and the like becomes continuous. The active clamping circuit is thereby activated. As a result, the output transistor T1 turns on, and the voltage of the output terminal OUT that has increased by the back-electromotive force is clamped to the clamping voltage (= the threshold voltage of the transistor Tr1 + the breakdown voltages of the Zener diodes D1_1 to D1_n + the threshold voltage of the transistor Tr5 + the forward voltage of the diode D3 + the dropping voltage by the resistor element R2). Overvoltage protection against the back-electromotive force is thereby performed.

Further, in the case where load dump occurs when the output transistor T1 is on, the voltage of the power supply voltage terminal Vcc2 and the voltage of the output terminal OUT increase. However, because the current flows through the load 4 and the output transistor T1, the voltage of the power supply voltage terminal Vcc2 becomes higher than the voltage of the output terminal OUT due to voltage drop by the resistance of the load 4. Accordingly, the comparator CMP1 outputs a comparison result at L level. The transistor Tr5 thereby turns off, and the current path P1 that passes through the Zener diodes D1_1 to D1_n and the like becomes non-continuous. The active clamping circuit is thereby inactivated. Thus, overvoltage protection against the load dump surge is not performed.

On the other hand, in the case where load dump occurs when the output transistor T1 is off, the voltage of the power supply voltage terminal Vcc2 and the voltage of the output terminal OUT increase. Because the current does not flow through the load 4 and the output transistor T1, the voltage of the power supply voltage terminal Vcc2 equals the voltage of the output terminal OUT. In this case also, in order to detect the occurrence of load dump, the comparator CMP1 is configured to intentionally have an offset voltage between the non-inverting input terminal and the inverting input terminal. To be specific, the comparator CMP1 is configured so that the inverting input terminal has a positive offset voltage to the non-inverting input terminal. The comparator CMP1 can thereby output a comparison result at L level even when load dump occurs during the off state of the output transistor T1. Specifically, the comparator CMP1 can accurately detect the occurrence of load dump even in the off state of the output transistor T1. When a comparison result at L level is output from the comparator CMP1, the transistor Tr5 turns off, and the current path P1 that passes through the Zener diodes D1_1 to D1_n and the like becomes non-continuous. The active clamping circuit is thereby inactivated. Thus, overvoltage protection against the load dump surge is not performed.

As described above, when a surge voltage is generated due to load dump or the like, the power controlling semiconductor device 10f inactivates the overvoltage protection function of the output transistor T1. It is thereby possible to prevent the surge voltage from being applied to the electronic control system. Further, in the power controlling semiconductor device 10f, the breakdown voltage of the output transistor T1 can be set to be as low as approximately the surge voltage due to load dump or the like, and it is thereby possible to reduce the area of the output transistor T1 and consequently reduce the cost.

### (Alternative Example of Power Controlling Semiconductor Device 10f)

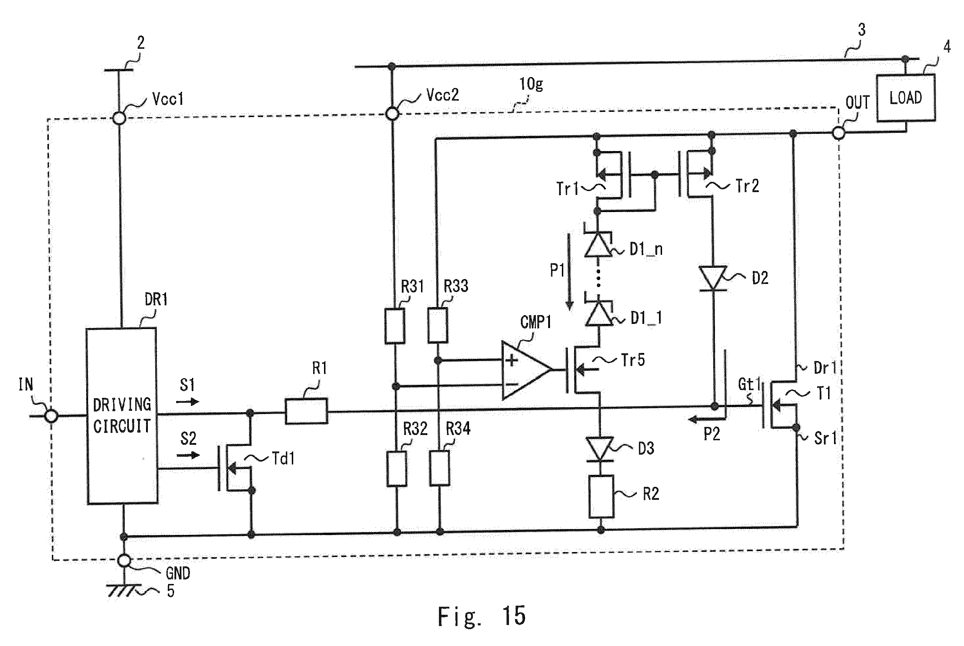

Fig. 15 is a view showing an alternative example of the power controlling semiconductor device 10f as a power controlling semiconductor device 10g.

As shown in Fig. 15, the power controlling semiconductor device 10g is different from the power controlling semiconductor device 10f in that it further includes resistor elements R31 to R34. To be specific, the resistor elements R31 and R32 are placed in series between the power supply voltage terminal Vcc2 and the ground voltage terminal GND. The resistor elements R33 and R34 are placed in series between the output terminal OUT and the ground voltage terminal GND. A node between the resistor elements R31 and R32 is connected to the inverting input terminal of the comparator CMP1, and a node between the resistor elements R33 and R34 is connected to the non-inverting input terminal of the comparator CMP1.

The resistor elements R31 and R32 output a low voltage that is obtained by resistance division of the voltage of the power supply voltage terminal Vcc2. The resistor elements R33 and R34 output a low voltage that is obtained by resistance division of the voltage of the output terminal OUT. It is thereby possible to prevent overvoltage from being applied to the inverting input terminal and the non-inverting input terminal of the comparator CMP1.

Note that elements other than the resistor elements R31 to R34 may be placed as long as it is possible to prevent the application of overvoltage to the inverting input terminal and the non-inverting input terminal of the comparator CMP1. For example, Zener diodes may be placed instead of the resistor elements R32 and R34.

### <Third Embodiment>

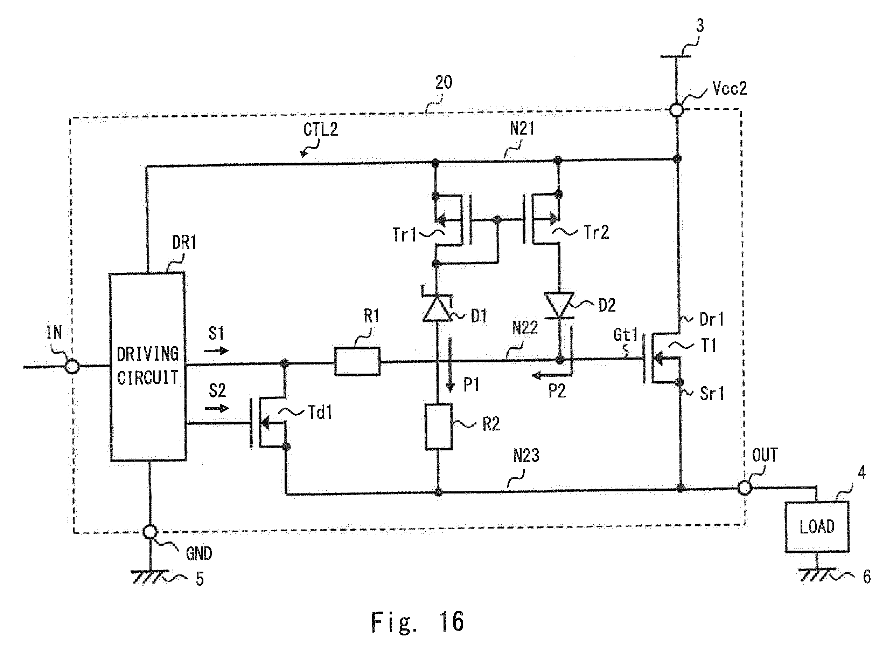

Fig. 16 is a view showing a structure example of a power controlling semiconductor device 20. While the output transistor T1 is used as a low side switch in the power controlling semiconductor device 10a, the output transistor T1 is used as a high side switch in the power controlling semiconductor device 20.

As shown in Fig. 16, the power controlling semiconductor device 20 includes the output transistor T1, the driving circuit DR1, the discharge transistor Td1, the Zener diode D1, the diode D2, the resistor element R1, the resistor element R2, the transistor Tr1 and the transistor Tr2, just like the power controlling semiconductor device 10a. The load 4 is placed between the output terminal OUT and a ground power supply 6.

Note that the ground power supply 6 may be shortcircuited with the ground power supply 5. Note that, however, when the output transistor T1 is used as a high side switch in an automobile and the like,
the ground power supply that is connected to the load 4 and the ground power supply that is connected to the power controlling semiconductor device 20 are different in many cases. In this case, a difference in potential occurs within a range of about 2V between the ground power supplies 5 and 6.

The drain Dr1 of the output transistor T1 is connected to the power supply voltage terminal Vcc2 through a node N21, and the source Sr1 of the output transistor T1 is connected to the output terminal OUT through a node N23. Then, a control signal S1 from the driving circuit DR1 is supplied to the gate Gt1 of the output transistor T1 through the resistor element R1 and a node N22. Specifically, the output transistor T1 is used as a high side switch that controls the current flowing through the load 4.

The drain of the discharge transistor Td1 is electrically connected to the gate Gt1 of the output transistor T1 through the resistor element R1, and the source of the discharge transistor Td1 is connected to the source Sr1 of the output transistor T1. The control signal S2 from the driving circuit DR1 is supplied to the gate of the discharge transistor Td1.

The driving circuit DR1 is driven with the power supply voltage Vcc2 and the ground voltage GND and outputs the controls signals S1 and S2 in accordance with the external input signal supplied from the outside to the input terminal IN.

The Zener diode D1, the diode D2 and the transistors Tr1 and Tr2 form a dynamic clamping circuit that protects the output transistor T1 from overvoltage. Generally, when current supply to the inductive load 4 is switched from on to off, electromagnetic energy stored in the load 4 is released and thereby a back-electromotive force is generated. In order to prevent the breakdown of the output transistor T1 due to the back-electromotive force, when a differential voltage between the power supply voltage terminal Vcc2 and the output terminal OUT becomes higher than a specified clamping voltage, the dynamic clamping circuit clamps the voltage of the output terminal OUT until the differential voltage between the power supply voltage terminal Vcc2 and the output terminal OUT becomes the clamping voltage..

To be specific, in the transistor Tr1, the source is connected to the power supply voltage terminal Vcc2 (in other words, the drain Dr1 of the output transistor T1), and the drain and the gate are connected to the gate of the transistor Tr2 and the cathode of the Zener diode D1. The anode of the Zener diode D1 is connected to the source Sr1 of the output transistor T1. In the transistor Tr2, the source is connected to the power supply voltage terminal Vcc2, and the drain is connected to the anode of the diode D2. The cathode of the diode D2 is connected to the gate Gt1 of the output transistor T1. The transistors Tr1 and Tr2 form a current mirror circuit.

Then, when a differential voltage between the power supply voltage terminal Vcc2 and the output terminal OUT exceeds a clamping voltage which is the sum of a breakdown voltage of the Zener diode D1 and a threshold voltage of the transistor Tr1, the voltage of the output terminal OUT is clamped until the differential voltage between the power supply voltage terminal Vcc2 and the output terminal OUT becomes the clamping voltage.

### (Operation of Power Controlling Semiconductor Device 20)

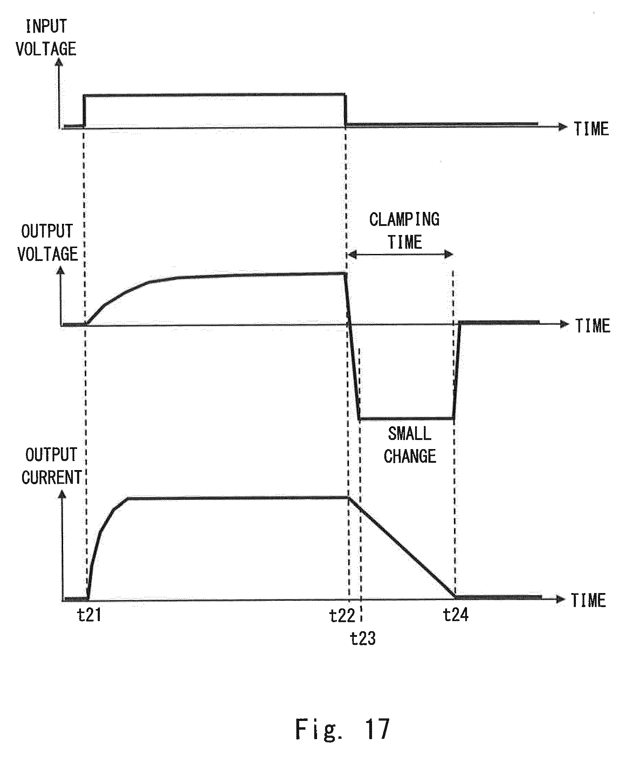

The operation of the power controlling semiconductor device 20 is described hereinafter with reference to Fig. 17.

Fig. 17 is a timing chart showing the operation of the power controlling semiconductor device 20. The case where the output transistor T1 turns on when the external input signal is H level and the output transistor T1 turns off when the external input signal is L level is described as an example.

First, when the external input signal changes from L level to H level (time t21), the driving circuit DR1 outputs the control signal S1 at H level and the control signal S2 at L level. As a result, the control signal S1 at H level, which is higher than a power supply voltage of the battery power supply 3, is supplied to the gate Gt1 of the output transistor T1, and the discharge transistor Td1 turns off by the control signal S2 at L level, and thereby the output transistor T1 turns on. Consequently, the current flows from the battery power supply 3 to the load 4. Note that, although the gate voltage of the output transistor T1 becomes higher than the drain voltage at this time, the backflow of the current from the gate Gt1 of the output transistor T1 to the drain Dr1 of the output transistor T1 through the transistor Tr2 is prevented by the diode D2.

After that, when the external input signal changes from H level to L level (time t22), the driving circuit DR1 outputs the control signal S1 at L level and the control signal S2 at H level. As a result, the control signal S1 at L level is supplied to the gate Gt1 of the output transistor T1. Further, because the discharge transistor Td1 turns on by the control signal S2 at H level, the charge at the gate Gt1 of the output transistor T1 is discharged to the output terminal OUT through the resistor element R1 and the discharge transistor Td1. The output transistor T1 thereby turns off. Consequently, the current flowing from the battery power supply 3 to the load 4 is cut off (time t24).

When the output transistor T1 is on, electromagnetic energy is stored in the inductive load 4. Thus, when the output transistor T1 is switched from on to off, the electromagnetic energy stored in the load 4 is released, and a back-electromotive force is generated in the reverse direction in the output terminal OUT. Consequently, a lower voltage than the ground power supply 6 is induced in the output terminal OUT (time t23).

When the differential voltage between the power supply voltage terminal Vcc2 and the output terminal OUT becomes higher than the clamping voltage (= the breakdown voltage of the Zener diode D1 + the threshold voltage of the transistor Tr1 + the dropping voltage by the resistor element R2) by the back-electromotive force, the current starts flowing from the power supply voltage terminal Vcc2 to the output terminal OUT through the transistor Tr1, the Zener diode D1 and the resistor element R2 (which is also referred to hereinafter as a current path P1). The current that is proportional to the current flowing through the transistor Tr1 thereby flows through the transistor Tr2. In other words, the current flows from the power supply voltage terminal Vcc2 to the output terminal OUT through the transistor Tr2, the diode D2, the resistor element R1 and the discharge transistor Td1 (which is also referred to hereinafter as a current path P2). The output transistor T1 thereby turns on because its gate voltage increases. The current thereby flows from the power supply voltage terminal Vcc2 to the output terminal OUT through the output transistor T1, and the voltage of the output terminal OUT is clamped to the clamping voltage (time t23 to time t24). At this time, the current flowing through the output terminal OUT (the current flowing through the load 4) continuously decreases exponentially by the release of electromagnetic energy.

Note that the clamping voltage is set to such a value that clamping is performed before the voltage between the drain Dr1 and the source Sr1 of the output transistor T1 exceeds the breakdown voltage. It is thereby possible to prevent the characteristics degradation and breakdown of the output transistor T1.

In the structure of the power controlling semiconductor device 20, just like the case of the power controlling semiconductor device 10a, the clamping voltage does not change with a change in the current flowing through the output terminal OUT, and therefore the clamping time is controlled accurately. To be specific, the clamping time is reduced. Consequently, the power controlling semiconductor device 20 can accurately drive the load 4. For example, when the power controlling semiconductor device 20 is mounted on the electronic control system of an automobile, a motorcycle or the like, it is possible to minimize the fuel injected during the clamping time. Further, because it is possible to correctly predict the clamping time, it is possible to accurately estimate the amount of fuel injection in consideration of the clamping time. As a result, it is possible to improve the engine fuel efficiency.

Further, in the structure of the power controlling semiconductor device 20, the supply source of a gate voltage for forcibly turning on the output transistor T1 at the time of clamping and the supply source of a power supply voltage to be supplied to the load 4 are the same. Therefore, the power controlling semiconductor device 20 can reliably turn on the output transistor T1 when the voltage of the output terminal OUT increases by the back-electromotive force.

Although the case where the output transistor T1 is used as a high side switch is described as an example in this embodiment, it is not limited thereto, and the output transistor T1 may be used as a low side switch.

Further, although the case where the resistor element R2 is placed as a current limiting element is described as an example in this embodiment, it is not limited thereto, and the resistor element R2 is not necessarily placed, as in the case of the power controlling semiconductor device 10.

### (Chip Mounting Example)

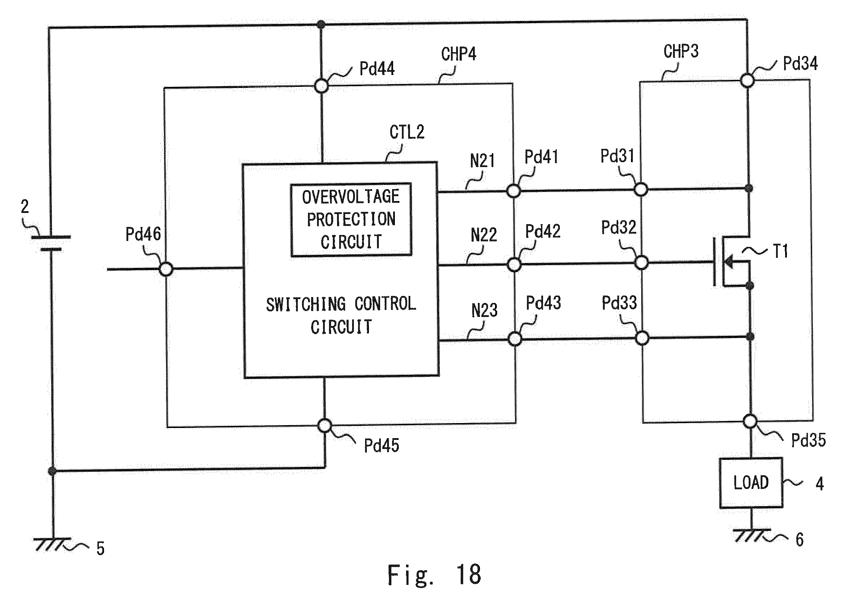

Fig. 18 is a view showing an example of mounting the power controlling semiconductor device 20 on a chip.

In the example of Fig. 18, the output transistor T1 and the switching control circuit CTL2 that constitute the power controlling semiconductor device 20 are placed on a chip CHP3 and a chip CHP4, respectively. Note that, however, the output transistor T1 and the switching control circuit CTL2 that constitute the power controlling semiconductor device 20 may be formed in monolithic.

The switching control circuit CTL2 that is placed on the chip CHP4 is supplied with an input signal for controlling on and off of the output transistor T1 from the outside through a pad Pd46, supplied with a power supply voltage from the battery power supply 2 through a pad Pd44, and supplied with a ground voltage from the ground power supply 5 through a pad Pd45. Then, nodes N21 to N23 of the switching control circuit CTL2 are connected with the drain Dr1, the gate Gt1 and the source Sr1 of the output transistor T1 placed on the chip CHP3 through pads Pd41 to Pd43 on the chip CHP4 and pads Pd31 to Pd33 on the chip CHP3. Note that the chips CHP3 and CHP4 are connected by a bonding wire.

Note that, in addition to an overvoltage protection circuit, another protection circuit may be placed in the switching control circuit CTL2. For example, an overcurrent protection circuit (not shown) that protects the output transistor T1 from overcurrent, an over temperature protection circuit (not shown) that protects the output transistor T1 from over temperature and the like may be placed in the switching control circuit CTL2. Further, terminals and pads for outputting output results of those protection circuits to the outside may be further placed. The state of the power controlling semiconductor device 20 is recognizable by observing the output results of those protection circuits, and it is thereby possible to enhance the safety of the function.

### (Alternative Example of Power Controlling Semiconductor Device 20)

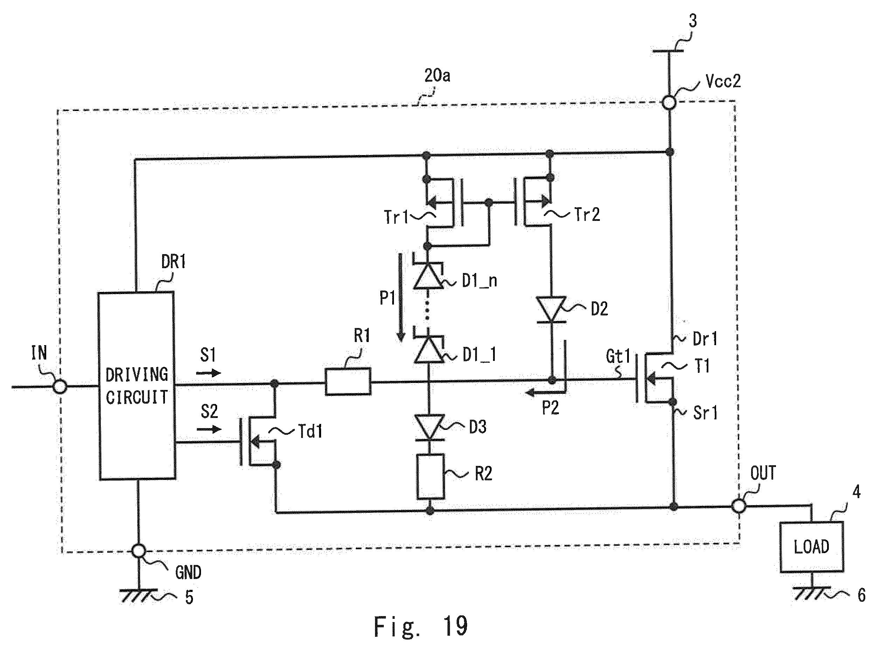

Fig. 19 is a view showing an alternative example of the power controlling semiconductor device 20 as a power controlling semiconductor device 20a.

As shown in Fig. 19, the power controlling semiconductor device 20a is different from the power controlling semiconductor device 20 in that it includes a plurality of Zener diodes D1_1 to D1_n that are connected in series, instead of the single Zener diode D1, and a diode D3 that is connected in series and reversed to them. To be specific, the anode of the diode D3 is connected to the anode of the Zener diode D1_1, and the cathode of the diode D3 is connected to one end of the resistor element R2. The other structure of the power controlling semiconductor device 20a is the same as that of the power controlling semiconductor device 20 and thus not redundantly described.

For each of the Zener diodes D1_1 to D1_n, a Zener diode with a breakdown voltage of about 6V and with a low temperature dependence is used. It is thereby possible to achieve a dynamic clamping circuit with less manufacturing variation and less temperature variation, just like the case of the power controlling semiconductor device 10d and the like. It is thus possible to achieve a dynamic clamping circuit with less variation in a clamping time.

The diode D3 is used together with the plurality of Zener diodes D1_1 to D1_n for further reduction of the temperature dependence of the current path P1. To be specific, when the plurality of Zener diodes D1_1 to D1_n show a positive temperature dependence, by placing the diode D3 having a negative temperature dependence, it is possible to further reduce the temperature dependence of the current path P1.

Note that the diode D3 is not necessarily placed if not need. Further, in place of the single diode D3, a plurality of diodes D3_1 to D3_m (m is an integer of 2 or above) connected in series may be placed. The number of Zener diodes D1 and the diodes D3 may be set arbitrarily.

### <Fourth Embodiment>

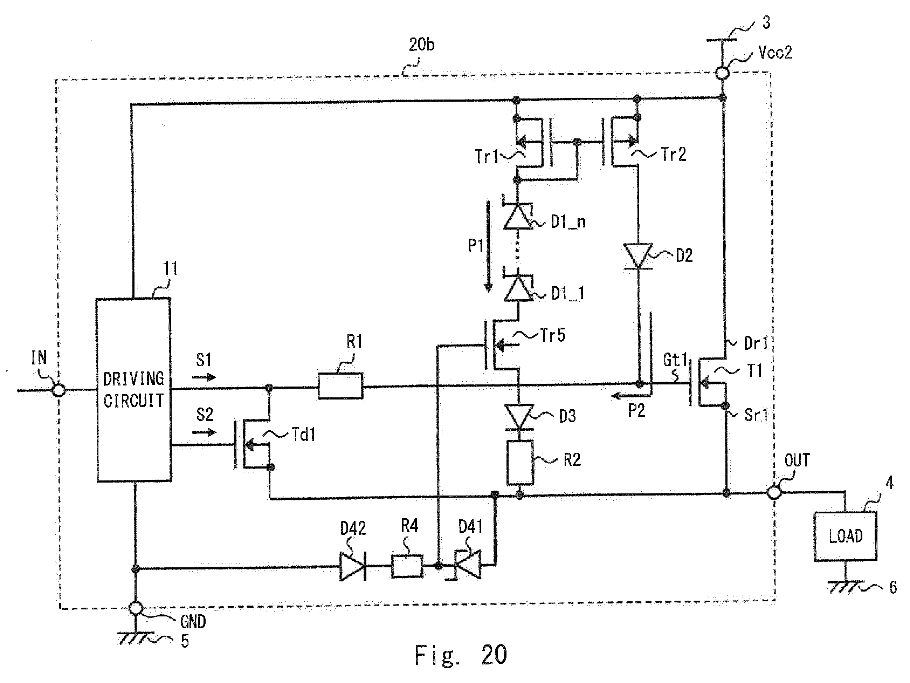

Fig. 20 is a view showing a structure example of a power controlling semiconductor device 20b according to a fourth embodiment.

The power controlling semiconductor device 20b has a function of inactivating the overvoltage protection function of an output transistor T1 when a surge voltage is generated due to load dump or the like in order to prevent the surge voltage from being applied to an electronic control system.

As shown in Fig. 20, the power controlling semiconductor device 20b is different from the power controlling semiconductor device 20 in that it further includes a transistor Tr5, a Zener diode D41, a diode D42, and a resistor element R4. The Zener diode D41, the diode D42 and the resistor element R4 form a voltage detection circuit.

The anode of the Zener diode D41 is connected to the output terminal OUT, and the cathode of the Zener diode D41 is connected to one end of the resistor element R4. The cathode of the diode D42 is connected to the other end of the resistor element R4, and the anode of the diode D42 is connected to the ground voltage terminal GND. The cathode of the Zener diode D41 is connected to the gate of the transistor Tr5. It is assumed that a breakdown voltage of the diode D42 is higher than a surge voltage by load dump.

The transistor Tr5 is placed on the current path P1 and switches on and off based on a cathode voltage of the Zener diode D41, thereby controlling the continuity of the current path P1. To be specific, in the transistor Tr5, the source is connected to the anode of the diode D3, the drain is connected to the anode of the Zener diode D1_1, and a cathode voltage of the Zener diode D41 is supplied to the gate.

While the back-electromotive force that is induced at the output terminal OUT by the inductive load 4 is a negative voltage, the surge voltage that is induced at the power supply voltage terminal Vcc2 by load dump is a positive voltage. Thus, it is relatively easy to determine which of the back-electromotive force and the load dump surge is generated. For example, the power controlling semiconductor device 20b allows the current path P1 to be continuous and thereby activates the dynamic clamping circuit only when the output terminal OUT has a negative voltage due to the back-electromotive force, and otherwise makes the current path P1 non-continuous and thereby inactivates the dynamic clamping circuit.

For example, when the voltage of the output terminal OUT becomes a negative voltage by the back-electromotive force, the voltage of the ground voltage terminal GND becomes higher than the voltage of the output terminal OUT, and thereby the current flows from the ground voltage terminal GND to the output terminal OUT through the voltage detection circuit. Consequently, a voltage which is higher than a voltage applied to the source of the transistor Tr5 by the amount of the breakdown voltage of the Zener diode D41 is applied to the gate of the transistor Tr5, and the transistor Tr5 turns on. Accordingly, the current path P1 that passes through the Zener diodes D1_1 to D1_n and the like becomes continuous. The active clamping circuit is thereby activated. As a result, the output transistor T1 turns on, and the voltage of the output terminal OUT that has decreased by the back-electromotive force increases until the differential voltage between the power supply voltage terminal Vcc2 and the output terminal OUT becomes the clamping voltage (= the threshold voltages of the transistors Tr5 and Tr6 + the breakdown voltages of the Zener diodes D1_1 to D1_n + the breakdown voltage of the diode D3). Overvoltage protection against the back-electromotive force is thereby performed.

Further, in the case where load dump occurs when the output transistor T1 is on, the voltage of the power supply voltage terminal Vcc2 increases. Further, when the on-resistance of the output transistor T1 is sufficiently low, a voltage drop between the drain Dr1 and the source Sr1 of the output transistor T1 due to the load current is sufficiently small, and therefore the voltage of the output transistor T1 increases to be substantially the same value as the voltage of the power supply voltage terminal Vcc2. However, because the breakdown voltage of the diode D42 is higher than the surge voltage by load dump as described above, the current does not flows from the output terminal OUT to the ground voltage terminal GND through the voltage detection circuit. The gate and the source of the transistor Tr5 thereby become the same potential, and the transistor Tr5 turns off. Accordingly, the current path P1 that passes through the Zener diodes D1_1 to D1_n and the like becomes non-continuous. The active clamping circuit is thereby inactivated. Thus, overvoltage protection against the load dump surge is not performed.

On the other hand, in the case where load dump occurs when the output transistor T1 is off, while the voltage of the power supply voltage terminal Vcc2 increases, the voltage of the output terminal OUT is the voltage value of the ground power supply 6. Because a potential difference between the ground power supplies 5 and 6 is about 2V or less, the current does not flow from the output terminal OUT to the ground voltage terminal GND through the voltage detection circuit. The gate and the source of the transistor Tr5 thereby become the same potential, and the transistor Tr5 turns off. Accordingly, the current path P1 that passes through the Zener diodes D1_1 to D1_n and the like becomes non-continuous. The active clamping circuit is thereby inactivated. Thus, overvoltage protection against the load dump surge is not performed. Note that, although a load dump surge is applied between the drain Dr1 and the source Sr1 of the output transistor T1, because the breakdown voltage of the output transistor T1 is higher than the surge voltage, the breakdown and damage of the output transistor T1 do not occur.

As described above, the power controlling semiconductor device 20b activates the overvoltage protection function of the output transistor T1 only when the output terminal OUT has a negative voltage due to the back-electromotive force. Therefore, when a surge voltage is generated due to load dump or the like, the overvoltage protection function of the output transistor T1 is inactivated. It is thereby possible to prevent the surge voltage from being applied to the electronic control system. Further, in the power controlling semiconductor device 20b, the breakdown voltage of the output transistor T1 can be set to be as low as approximately the surge voltage due to load dump or the like, and it is thereby possible to reduce the area of the output transistor T1 and consequently reduce the cost.

It should be noted that the elements of the voltage detection circuit are not limited to those described the above, and they may be replaced by other elements having the same functions. For example, an MOS transistor where the gate and the source are short-circuited may be placed instead of the diode D42.

### (Alternative Example of Power Controlling Semiconductor Device 20b)

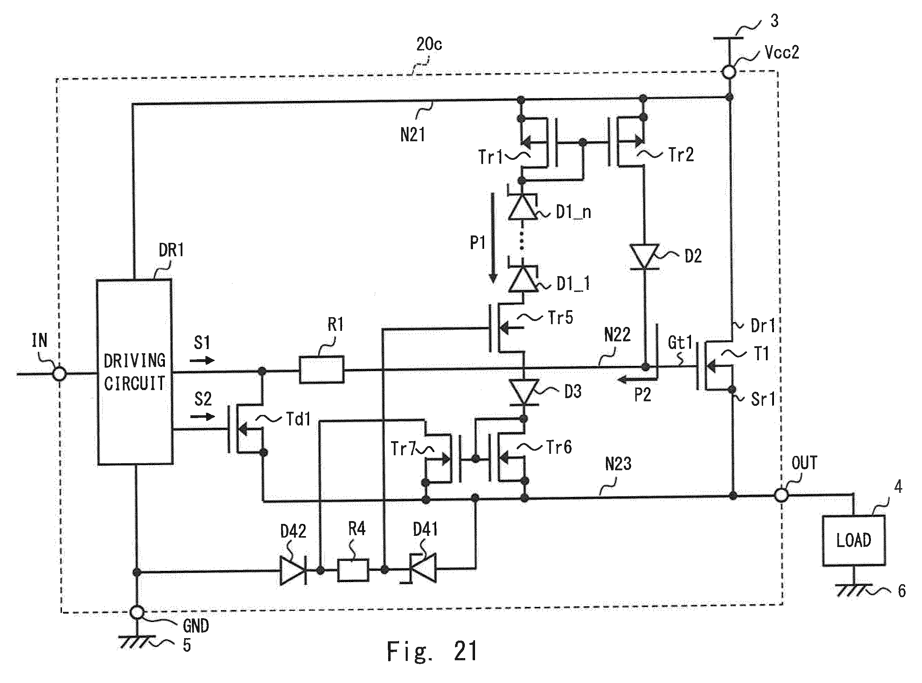

Fig. 21 is a view showing an alternative example of the power controlling semiconductor device 20b as a power controlling semiconductor device 20c.

As shown in Fig. 21, the power controlling semiconductor device 20c is different from the power controlling semiconductor device 20b in that it includes a transistor Tr6 in placed of the resistor element R2 and further includes a transistor Tr7. Hereinafter, the case where the transistors Tr6 and Tr7 are N-channel MOS transistors is described as an example.

In the transistor Tr6, the drain and the gate are connected to the cathode of the diode D3 and the gate of the transistor Tr7, and the source is connected to the output terminal OUT. In the transistor Tr7, the drain is connected to the cathode of the diode D42, and the source is connected to the output terminal OUT.

Note that the transistors Tr6 and Tr7 form a current mirror circuit. Further, the transistor Tr6 serves as a current limiting element that limits the current flowing through the Zener diodes D1_1 to D1_n when the current path P1 is continuous. By limiting the current flowing through the Zener diodes D1_1 to D1_n, it is possible to stabilize the breakdown voltage of the Zener diodes D1_1 to D1_n.

Further, the transistor Tr7, together with the resistor element R4, serves as a current limiting element that limits the current flowing through the Zener diode D41. By limiting the current flowing through the Zener diode D41, it is possible to stabilize the breakdown voltage of the Zener diode D41.

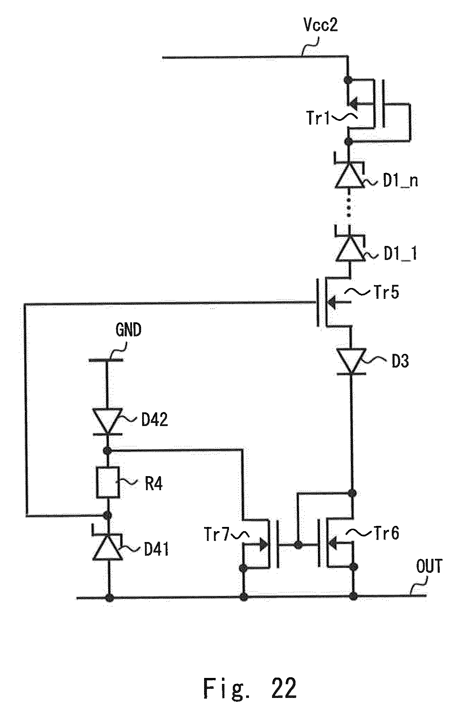

Fig. 22 is a view to describe the effects of the power controlling semiconductor device 20c in more detail. Fig. 22 shows the current path P1 and a circuit diagram of the voltage detection circuit in the power controlling semiconductor device 20c.

When the voltage of the output terminal OUT becomes a negative voltage due to the back-electromotive force or the like, and the current starts flowing from the ground voltage terminal GND to the output terminal OUT through the voltage detection circuit, the transistor Tr5 turns on because of an increase in its gate voltage, and thereby the current path P1 including the transistor Tr6 becomes continuous. The active clamping circuit is thereby activated. As a result, the output transistor T1 turns on, and the voltage of the output terminal OUT that has decreased by the back-electromotive force increases until the differential voltage between the power supply voltage terminal Vcc2 and the output terminal OUT becomes the clamping voltage (= the threshold voltages of the transistors Tr1, Tr5 and Tr6 + the breakdown voltages of the Zener diodes D1_1 to D1_n + the breakdown voltage of the diode D3).

When the current starts flowing through the current path P1 including the transistor Tr6, the current that is proportional to the current flowing through the transistor Tr6 flows through the transistor Tr7. Specifically, two current paths, which are a current path that includes the diode D42, the resistor element R4 and the Zener diode D41 and a current that includes the diode D42 and the transistor Tr7, are formed between the ground voltage terminal GND and the output terminal OUT. The current flowing through the Zener diode D41 is thereby limited without increasing the resistance value of the resistor element R4, and it is possible to stabilize the breakdown voltage of the Zener diode D41. It is thereby possible to reliably protect the gate of the transistor Tr6.

The other structure and operation of the power controlling semiconductor device 20c are the same as those of the power controlling semiconductor device 20b and thus not redundantly described.

As described above, the power controlling semiconductor devices according to the first to fourth embodiments include the Zener diode D1 that allows the source Sr1 and the drain Dr1 of the output transistor T1 to be continuous when a voltage between the source Sr1 and the drain Dr1 of the output transistor T1 exceeds a clamping voltage, and the transistors Tr1 and Tr2 that allow a current to flow between the source Sr1 and the gate Gt1 of the output transistor T1 when a current flows through the Zener diode D1. Thus, the clamping voltage does not change with a change in the current flowing through the output terminal OUT during clamping, and therefore it is possible to accurately control the clamping time. To be specific, it is possible to reduce the clamping time. Consequently, it is possible to accurately drive the load 4. For example, when the power controlling semiconductor devices according to the first to fourth embodiments are mounted on electronic control systems of automobiles, motorcycles and the like, it is possible to minimize the fuel injected during the clamping time. Further, because it is possible to correctly predict the clamping time, it is possible to accurately estimate the amount of fuel injection in consideration of the clamping time. As a result, it is possible to improve the engine fuel efficiency.

Although the case where the output transistor T1 is a power MOS transistor is described in the first to fourth embodiments, the output transistor T1 can be formed using a trench cell in various shapes and structures. For example, the output transistor T1 may be a trench or planar MOS transistor. Further, the output transistor T1 may be any structure of a vertical or horizontal MOS transistor.

Alternatively, in the case where the output transistor T1 is a bipolar transistor, the output transistor T1 may be any structure of a gate insulating bipolar transistor, for example. As a matter of course, the output transistor T1 may be a cell structure other than that. Further, a unit cell structure that constitutes a power MOS transistor is not limited to stripe, and it may be any shape such as hexagon or square.

Further, the power controlling semiconductor devices according to the first to fourth embodiments may be packaged as a power semiconductor device or may be used as a bare chip. Further, the output transistor T1 and the switching control circuit that constitute the power controlling semiconductor device may be formed on monolithic (one die) or formed on separate chips (dies).

Furthermore, the power controlling semiconductor devices according to the first to fourth embodiments may be applied not only to fuel injection systems of automobiles, motorcycles and the like, but also to other electronic control systems. For example, they may be applied to driving of solenoids of automobiles, driving of motors used for industrial robots and the like, really control of sequencers and the like.

Although embodiments of the present invention are described specifically in the foregoing, the present invention is not restricted to the above-described embodiments, and various changes and modifications may be made without departing from the scope of the invention.

For example, in the semiconductor device according to the above embodiment, the conductivity type (P type or N type) of a semiconductor substrate, a semiconductor layer, a diffusion layer (diffusion region) and the like may be inverted. Accordingly, when one conductivity type of N type and P type is a first conductivity type and the other conductivity type thereof is a second conductivity type, the first conductivity type may be P type and the second conductivity type may be N type, or the first conductivity type may be N type and the second conductivity type may be P type on the contrary.

The first to fourth embodiments can be combined as desirable by one of ordinary skill in the art.

While the invention has been described in terms of several embodiments, those skilled in the art will recognize that the invention can be practiced with various modifications within the scope of the appended claims and the invention is not limited to the examples described above.

Further, the scope of the claims is not limited by the embodiments described above.

Furthermore, it is noted that, Applicant's intent is to encompass equivalents of all claim elements, even if amended later during prosecution.

## Claims

1. A semiconductor device comprising:
a voltage limiting circuit that, when a voltage between a first terminal and a second terminal of an output transistor that controls a current flowing through a load exceeds a specified value, allows continuity between the first terminal and the second terminal of the output transistor; and
a first current mirror circuit that, when a current flows through the voltage limiting circuit, allows continuity between the first terminal and a control terminal of the output transistor.

2. The semiconductor device according to Claim 1,
wherein the first current mirror circuit includes:
a first transistor placed in series to the voltage limiting circuit; and
a second transistor placed between the first terminal and the control terminal of the output transistor, where a current proportional to the first transistor flows.

3. The semiconductor device according to Claim 1, further comprising:
a second current mirror circuit, wherein
the second current mirror circuit includes:
a third transistor placed in series to the voltage limiting circuit; and
a fourth transistor where a current proportional to the third transistor flows, and
the first current mirror circuit includes:
a first transistor placed in series to the fourth transistor; and
a second transistor placed between the first terminal and the control terminal of the output transistor, where a current proportional to the first transistor flows.

4. The semiconductor device according to Claim 1, further comprising:
a first diode that prevents backflow of a current from the control terminal to the first terminal of the output transistor.

5. The semiconductor device according to Claim 1, further comprising:
a discharge transistor placed between the second terminal and the control terminal of the output transistor and controlled to turn on when the output transistor turns off; and
a resistor element placed in series to the discharge transistor between the second terminal and the control terminal of the output transistor.

6. The semiconductor device according to Claim 1,
wherein the voltage limiting circuit is one or a plurality of Zener diodes.

7. The semiconductor device according to Claim 6, further comprising:
one or a plurality of second diodes that are placed in series and reversed to the one or plurality of Zener diodes.

8. The semiconductor device according to Claim 6, further comprising:
a current limiting element placed in series to the voltage limiting circuit.

9. The semiconductor device according to Claim 1,
wherein
the load is placed between a buttery power supply and the first terminal of the output transistor, and
the semiconductor device further comprises:
a first comparator that compares a voltage of the buttery power supply and a voltage of the first terminal of the output transistor; and
a fifth transistor placed in series to the voltage limiting circuit and controlled to turn on and off based on a comparison result of the first comparator.

10. The semiconductor device according to Claim 9, further comprising:
a group of resistor elements that divide voltages of the battery power supply and the first terminal of the output transistor, wherein
the first comparator compares voltages of the battery power supply and the first terminal of the output transistor divided by the group of resistor elements.

11. The semiconductor device according to Claim 1,
wherein
the load is placed between a ground power supply and the second terminal of the output transistor, and
the semiconductor device further comprises:
a voltage detection circuit that detects a voltage of the second terminal of the output transistor; and
a fifth transistor placed in series to the voltage limiting circuit and controlled to turn on and off based on a detection result of the voltage detection circuit.

12. The semiconductor device according to Claim 11,
wherein
the voltage detection circuit includes a voltage detection diode, a voltage detection resistor, and a voltage detection Zener diode placed in series between a second ground power supply different from the ground power supply connected to the load and the second terminal of the output transistor, and
the semiconductor device further comprises:
a sixth transistor placed in series to the voltage limiting circuit; and
a seventh transistor placed between a node between the voltage detection diode and the voltage detection resistor and the second terminal of the output transistor, where a current proportional to the sixth transistor flows.

13. A power controlling semiconductor device comprising:
the semiconductor device according to Claim 1; and
the output transistor.

14. An on-vehicle electronic control unit comprising:
one or a plurality of power controlling semiconductor devices that control a current flowing through one or a plurality of loads; and
a processor that gives an instruction to the one or plurality of power controlling semiconductor devices based on information from a sensor placed externally, wherein
each of the one or plurality of power controlling semiconductor devices includes:
an output transistor that controls a current flowing through the corresponding load;
a voltage limiting circuit that, when a voltage between a first terminal and a second terminal of the output transistor exceeds a specified value, allows continuity between the first terminal and the second terminal of the output transistor; and
a first current mirror circuit that, when a current flows through the voltage limiting circuit, allows continuity between the first terminal and a control terminal of the output transistor.

15. The on-vehicle electronic control unit according to Claim 14, wherein the one or plurality of loads are solenoid injectors placed in an engine of a vehicle.

16. A vehicle equipped with the on-vehicle electronic control unit according to Claim 15.
